# EUROPEAN PATENT SPECIFICATION

(11) **EP 4 492 931 B1**
(45) Date of publication and mention of the grant of the patent: **30.09.2026**
(21) Application number: 23829554.7
(22) Date of filing: 30.03.2023
(51) Int. Cl.: H05K 5/02, H05K 7/14

(54) **ELECTRONIC DEVICE, CABINET, AND SERVER**
ELEKTRONISCHE VORRICHTUNG, SCHRANK UND SERVER
DISPOSITIF ÉLECTRONIQUE, ARMOIRE ET SERVEUR

(30) Priority: 30.06.2022 CN 202210760398
(43) Date of publication of application: 15.01.2025
(73) Proprietor: xFusion Digital Technologies Co., Ltd., Zhengzhou, Henan 450000 (CN)
(72) Inventor: KANG, Jia, Zhengzhou, Henan 450000 (CN); LIU, Honghui, Zhengzhou, Henan 450000 (CN); JIAO, Haiqing, Zhengzhou, Henan 450000 (CN)
(74) Representative: MERH-IP Matias Erny Reichl Hoffmann Patentanwälte PartG mbB
(86) International application number: PCT/CN2023/085255
(87) International publication number: WO 2024/001364

(56) References cited:
- CN-A- 102 882 267
- CN-A- 105 468 109
- CN-A- 110 427 093
- CN-A- 115 175 508
- CN-U- 204 316 893
- CN-U- 215 682 932
- JP-B2- 6 369 004
- US-A1- 2017 354 053
- US-B2- 8 138 634

## Description

### TECHNICAL FIELD

The present invention relates to the field of power technology, and, to an electronic device, a cabinet, and a server.

### BACKGROUND

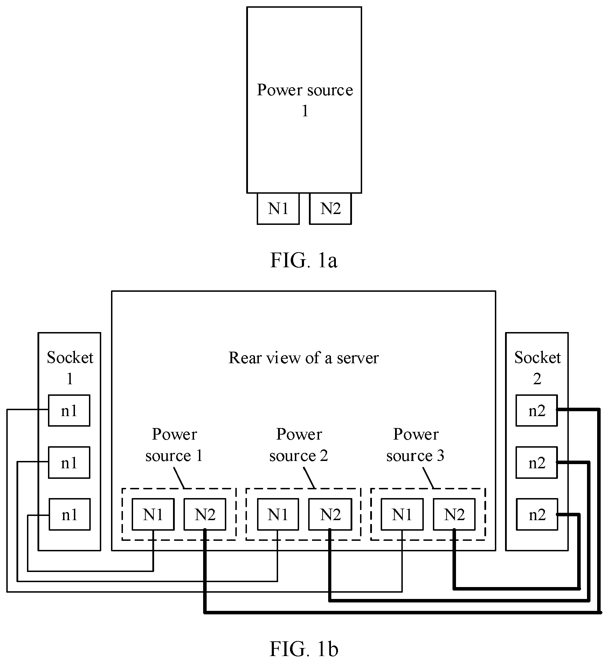

With the application of the Internet, needs for information transmission and sharing in various industries are growing, and scale and quantity of data centers that provide an infrastructure for information transmission and storage are continuously expanding. In addition, various performance requirements of a data center server are continuously increased. As a result, power consumption of the server is continuously increased, and a quantity of power sources PSUs of a server or a cabinet are also continuously increased. For data centers in the fields such as finance and communications, there is a high requirement for reliability of the server, and a dual-input power source is a preferred option. As shown in FIG. 1a, a dual-input power source has two ports N1 and N2. N1 is a primary input port, and a power supply manner thereof is mains power. N2 is a backup input port, and a power supply manner thereof is generally another power supply manner other than the mains power, for example, power supply by using a self-provided generator.

When a plurality of dual-input power sources are disposed for the server or the cabinet, because N1 and N2 are alternately arranged, power cables of the plurality of power sources cross. This affects cables organized, and occupies at least 1U space (U is a unit representing an external size of the server, and is an abbreviation for unit, where 1U is 4.45 cm) of the cabinet.

In conclusion, when a plurality of dual-input power sources are disposed for the server or the cabinet, because there are a large quantity of power cables, cables organized becomes a major problem. An improper arrangement relationship between ports of the power sources increases cables organized difficulty, excessively occupies space of the cabinet, and affects deployment and space utilization of the data center servers. Therefore, a technical solution that can be used to flexibly change the arrangement relationship between the ports of the power sources to reduce cables organized difficulty is urgently required.

Information disclosed in the BACKGROUND part is intended only to enhance the understanding of the overall background of the present invention, and should not be considered or implied in any form as constituting the conventional technology known to a person of ordinary skill in the art.
Document JP 6369004B2 relates to an electronic device that includes a power supply member and liquid-cooled substrates. The power supply member includes a power supply unit and a bus bar unit, and the power supply unit is electrically connected to the liquid-cooled substrate by the bus bar unit.

### SUMMARY

The present invention is defined by the appended claims. In the following, parts of the description and drawings referring to former embodiments which do not necessarily comprise all features to implement embodiments of the claimed invention are understood to not represent embodiments of the invention but to relate to be examples useful for understanding the embodiments of the invention. Embodiments of the present invention provide an electronic device, a cabinet, and a server. External power ports adapted to power input ports are added, and the power input ports are cross-connected to the external power ports to transform a first structure, formed by the power input ports, into a second structure formed by the external power ports, so as to rearrange the power input ports. Because a location of a power source does not need to be considered, layout of the external power port may be flexibly designed based on a requirement, thereby reducing cables organized difficulty and meeting a cables organized requirement. In addition, connection is performed through cabling inside the electronic device, to implement structure transformation, so that no external space of the electronic device is occupied. Moreover, a quantity of power sources is not limited, and the quantity of power sources may be set based on an actual requirement.

According to a first aspect, an embodiment of the present invention provides an electronic device, including a plurality of power sources, a connection module, and a housing, where
each power source is located inside the housing, at least two power input ports are disposed for each power source, the plurality of power sources have a target quantity of power input ports in total, and the target quantity of power input ports form a first structure;
the connection module includes the target quantity of first power ports, and the target quantity of first power ports are disposed on the housing; and
the target quantity of first power ports on the housing form a second structure, the first structure is different from the second structure, and the target quantity of power input ports are connected to the target quantity of first power ports in a one-to-one correspondence, so that the first structure is transformed into the second structure.

In this solution, external power ports adapted to the power input ports are added, and the power input ports are connected to the external power ports to transform the first structure, formed by the power input ports, into the second structure formed by the external power ports, so as to rearrange the power input ports. Because a location of a power source does not need to be considered, layout of the external power port may be flexibly designed based on a requirement, thereby reducing cables organized difficulty and meeting a cables organized requirement. In addition, connection is performed through cabling inside the electronic device, to implement structure transformation, so that no external space of the electronic device is occupied. Moreover, a quantity of power sources is not limited, and the quantity of power sources may be set based on an actual requirement.

In a possible implementation, the second structure is used to connect to a plurality of sockets without cross-cabling, so that cables outside the housing of the electronic device connect to the sockets without cross-connect.

In a possible implementation, the second structure forms a plurality of third structures, and the plurality of third structures are respectively connected to the plurality of sockets in a one-to-one correspondence without cross-cabling.

In a possible implementation, the at least two power input ports of the power source respectively correspond to a same power specification and different power supply manners, and the third structures are connected, by the first power ports, to power input ports that are of different power sources and that have a same power specification and a same power supply manner.

In this solution, a plurality of dual-input power sources can be connected to a plurality of sockets without cross-cabling.

In a possible implementation, the plurality of power sources include a plurality of target power sources, the at least two power input ports of each target power source include at least one first-type power input port and at least one second-type power input port, a power supply manner of the first-type power input port is a primary power supply manner, and a power supply manner of the second-type power input port is a backup power supply manner; and the plurality of sub-structures include a primary power supply structure and a backup power supply structure, the primary power supply structure is connected to the first-type power input port, and the backup power supply structure is connected to the second-type power input port.

In this solution, the second structure can be used to connect power input ports in a primary power supply manner and power input ports in a backup power supply manner of different power sources without cross-cabling. Specifically, in this solution, a plurality of dual-input power sources can be connected to a plurality of sockets without cross-cabling.

In a possible implementation, the plurality of sockets are disposed outside the electronic device and are located on one side or opposite sides of the plurality of power sources.

In this solution, the sockets are disposed on one side or opposite sides to facilitate cabling.

In a possible implementation, the power input port is connected to the first power port by a power cable.

In this solution, the ports are connected by the power cable, and a location of the first power port on the housing can be flexibly set, to meet a cables organized requirement.

In a possible implementation, locations of orthographic projections of the target quantity of power input ports on the housing are different from locations of the target quantity of first power ports.

In this solution, the location of the power source does not restrict the location of the first power port on the housing. Therefore, the location of the first power port and the location of the power input port may no longer correspond to each other. When the location corresponding to the power source is occupied, the first power port may be disposed at another location. This better meets a cables organized requirement, and may also ensure aesthetics.

In a possible implementation, the power input port is connected to the first power port by a power conversion board, a side that is of the power conversion board and that is close to the plurality of power sources is connected to the power input port, and a side that is of the power conversion board and that is close to the plurality of connection modules is connected to the first power port.

In this solution, the ports are connected by the power conversion board, and space inside the electronic device is not excessively occupied, so that the first power port can be connected to the power input port quickly and accurately.

In a possible implementation, the at least two power input ports of the power source are connected to a board connection module, and the board connection module is connected to the power conversion board, to connect the at least two power input ports of the power source to the power conversion board by the board connection module.

In this solution, all power input ports of one power source are connected by the board connection module, to further improve efficiency of connection between the first power port and the power input port.

In a possible implementation, some or all of the plurality of power sources are arranged into a straight line or matrix.

In this solution, an arrangement manner of the plurality of power sources is not limited.

In a possible implementation, the plurality of power sources are disposed at a bottom, middle, or upper part of the electronic device.

In this solution, locations of the plurality of power sources in the electronic devices are not limited.

According to a second aspect, an embodiment of the present invention provides a cabinet, where at least one electronic device is disposed in the cabinet, and the any electronic device is the electronic device according to the first aspect.

For beneficial effects in this solution, refer to the foregoing descriptions. Details are not described again.

In a possible implementation, a plurality of sockets are disposed in the cabinet, a second structure of each of the at least one electronic device is used to connect to the plurality of sockets without cross-cabling, so that the plurality of electronic device receive power supply transmitted by the plurality of sockets.

In this solution, the sockets are placed inside the cabinet, and cabling is implemented inside the cabinet, so that space outside the cabinet is not occupied.

In a possible implementation, the plurality of sockets are disposed on one side or opposite sides of the plurality of electronic devices.

In this solution, the sockets are disposed on one side or opposite sides to facilitate cabling.

According to an example not covered by the claims but useful for understanding the application, an embodiment of the present invention provides a cabinet, where a plurality of electronic devices are disposed in the cabinet, the cabinet includes a plurality of power sources, a connection module, a connection board, and a housing, the plurality of power sources are configured to supply power to the plurality of electronic devices;
each power source is located inside the housing, at least two power input ports are disposed for each power source, the plurality of power sources have a target quantity of power input ports in total, and the target quantity of power input ports are of a first structure;
the connection module is located inside the housing, and includes the target quantity of first power ports, and the target quantity of first power ports are disposed on the connection board;
the target quantity of first power ports on the connection board are of a second structure, and the first structure is different from the second structure; and
the target quantity of power input ports are cross-connected to the target quantity of first power ports in a one-to-one correspondence, so that the first structure is transformed into the second structure.

For beneficial effects in this solution, refer to the foregoing descriptions. Details are not described again.

In a possible implementation, the second structure is used to connect to a plurality of sockets without cross-cabling, so that the plurality of sources receive power supply transmitted by the plurality of sockets.

In a possible implementation, the cabinet further includes the plurality of sockets.

In this solution, the sockets are placed inside the cabinet, and cabling is implemented inside the cabinet, so that space outside the cabinet is not occupied.

In a possible implementation, the plurality of sockets are located on one side or opposite sides of the plurality of power sources.

In a possible implementation, the second structure forms a plurality of third structures, cabling of the plurality of third structures does not cross, and the plurality of third structures are respectively connected to the plurality of sockets in a one-to-one correspondence without cross-cabling.

In a possible implementation, the at least two power input ports of the power source respectively correspond to a same power specification and different power supply manners, and the third structures are connected, by the first power ports, to power input ports that are of different power sources and that have a same power specification and a same power supply manner.

In a possible implementation, the plurality of power sources include a plurality of target power sources, the at least two power input ports of each target power source include at least one first-type power input port and at least one second-type power input port, a power supply manner of the first-type power input port is a primary power supply manner, and a power supply manner of the second-type power input port is a backup power supply manner; and the plurality of sub-structures include a primary power supply structure and a backup power supply structure, the primary power supply structure is connected to the first-type power input port, and the backup power supply structure is connected to the second-type power input port.

In a possible implementation, the power input port is connected to the first power port by a power cable.

In a possible implementation, locations of orthographic projections of the target quantity of power input ports on the housing are different from locations of the target quantity of first power ports.

In a possible implementation, the power input port is connected to the first power port by a power conversion board, a side that is of the power conversion board and that is close to the plurality of power sources is connected to the power input port, and a side that is of the power conversion board and that is close to the plurality of connection modules is connected to the first power port.

In a possible implementation, the at least two power input ports of the power source are connected to a board connection module, and the board connection module is connected to the power conversion board, to connect the at least two power input ports of the power source to the power conversion board by the board connection module.

In a possible implementation, some or all of the plurality of power sources are arranged into a straight line or matrix.

In a possible implementation, the plurality of power sources are disposed at a bottom, middle, or upper part of the cabinet.

According to another example not covered by the claims but useful for understanding the application, an embodiment of the present invention provides a server, where the server includes at least one electronic device, and the any electronic device is the electronic device according to the first aspect.

In a possible implementation, the server is placed in a cabinet, a plurality of sockets are disposed in the cabinet, and first power ports inside the cabinet are connected to the plurality of sockets without cross-cabling, so that space outside the cabinet is not occupied.

For example, the plurality of sockets are disposed on one side or opposite sides of the server.

### BRIEF DESCRIPTION OF DRAWINGS

FIG. 1a is an example diagram of a power source according to an embodiment of the present invention;
FIG. 1b is an example diagram 1 of cabling for connecting a power source to a socket according to an embodiment of the present invention;
FIG. 1c is an example diagram 2 of cabling for connecting a power source to a socket according to an embodiment of the present invention;
FIG. 2 is an example diagram 1 of connecting a power source to a connection module according to an embodiment of the present invention;
FIG. 3a is an example diagram 2 of connecting a power source to a connection module according to an embodiment of the present invention;
FIG. 3b is an example diagram 3 of connecting a power source to a connection module according to an embodiment of the present invention;
FIG. 4a is a schematic diagram 1 of connecting an external power port to a socket according to an embodiment of the present invention;
FIG. 4b is a schematic diagram 2 of connecting an external power port to a socket according to an embodiment of the present invention;
FIG. 4c is a schematic diagram 3 of connecting an external power port to a socket according to an embodiment of the present invention;
FIG. 4d is a schematic diagram 4 of connecting an external power port to a socket according to an embodiment of the present invention;
FIG. 4e is a schematic diagram 5 of connecting an external power port to a socket according to an embodiment of the present invention;
FIG. 4f is a schematic diagram 6 of connecting an external power port to a socket according to an embodiment of the present invention;
FIG. 4g is a schematic diagram 7 of connecting an external power port to a socket according to an embodiment of the present invention;
FIG. 4h is a schematic diagram 8 of connecting an external power port to a socket according to an embodiment of the present invention;
FIG. 4i is a schematic diagram 9 of connecting an external power port to a socket according to an embodiment of the present invention;
FIG. 5a is a schematic diagram 1 of connecting external power ports of a plurality of electronic devices in a cabinet to a plurality of sockets in the cabinet according to an embodiment of the present invention;
FIG. 5b is a schematic diagram 2 of connecting external power ports of a plurality of electronic devices in a cabinet to a plurality of sockets in the cabinet according to an embodiment of the present invention;
FIG. 5c is a schematic diagram 3 of connecting external power ports of a plurality of electronic devices in a cabinet to a plurality of sockets in the cabinet according to an embodiment of the present invention;
FIG. 6 is a schematic diagram of arrangement of power sources of a cabinet according to an embodiment of the present invention;
FIG. 7a is a schematic diagram 1 of connecting a socket to an external power port on a housing of the cabinet provided in FIG. 6;
FIG. 7b is a schematic diagram 2 of connecting a socket to an external power port on a housing of the cabinet provided in FIG. 6;
FIG. 7c is a schematic diagram 3 of connecting a socket to an external power port on a housing of the cabinet provided in FIG. 6;
FIG. 7d is a schematic diagram 4 of connecting a socket to an external power port on a housing of the cabinet provided in FIG. 6;
FIG. 8a is a schematic diagram 1 of connecting an external power port to a socket in the cabinet provided in FIG. 6;
FIG. 8b is a schematic diagram 2 of connecting an external power port to a socket in the cabinet provided in FIG. 6;
FIG. 8c is a schematic diagram 3 of connecting an external power port to a socket in the cabinet provided in FIG. 6; and
FIG. 8d is a schematic diagram 4 of connecting an external power port to a socket in the cabinet provided in FIG. 6.

### DESCRIPTION OF EMBODIMENTS

To make the objectives, technical solutions, and advantages of the embodiments of the present invention clearer, the following describes the technical solutions of the embodiments of the present invention with reference to the accompanying drawings.

In the descriptions of the embodiments of the present invention, the word such as "example", "for example", or "such as" is used to represent giving an example, an illustration, or a description. Any embodiment or design scheme described as "example", "for example", or "such as" in the embodiments of the present invention should not be explained as being more preferred or having more advantages than another embodiment or design scheme. Exactly, use of the word "example", "for example", or "such as" is intended to present a relative concept in a specific manner.

In the descriptions of the embodiments of the present invention, the term "and/or" describes only an association relationship for describing associated objects and represents that three relationships may exist. For example, A and/or B may represent the following three cases: Only A exists, only B exists, and both A and B exist. In addition, unless otherwise specified, the term "a plurality of" means two or more than two. For example, a plurality of systems mean two or more than two systems, and a plurality of terminals mean two or more than two terminals.

In addition, the terms "first" and "second" are merely intended for a purpose of description, and shall not be understood as an indication or implication of relative importance or implicit indication of indicated technical features. Therefore, a feature limited by "first" or "second" may explicitly or implicitly include one or more features. The terms "include", "have", and their variants all mean "include but are not limited to", unless otherwise specifically emphasized in another manner.

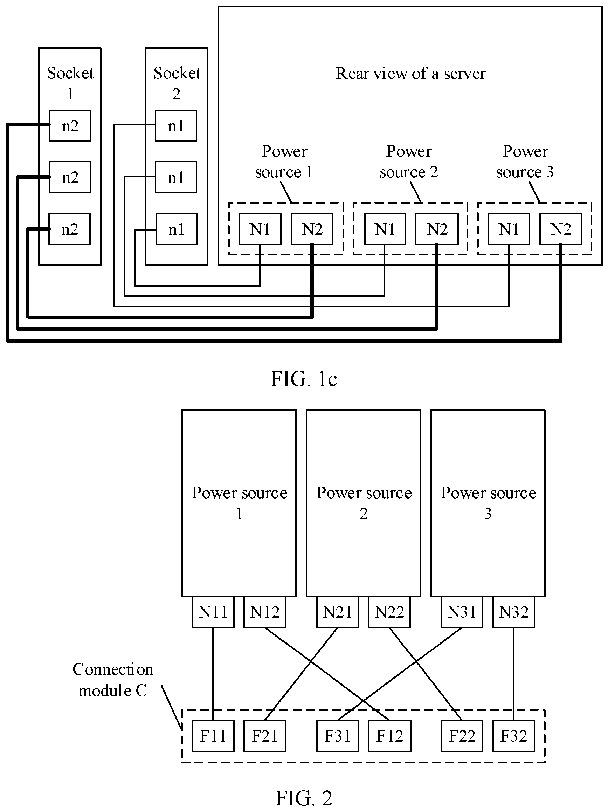

With the application of the Internet, needs for information transmission and sharing in various industries are growing, and a scale and a quantity of data centers that provide an infrastructure for information transmission and storage are continuously expanding. In addition, various performance requirements of a data center server are continuously increased. As a result, power consumption of the server is continuously increased, and a quantity of power sources, PSUs of a server or a cabinet are also continuously increased. For data centers in the fields such as finance and communications, there is a high requirement for reliability, and a dual-input power source is a preferred option. As shown in FIG. 1a, a dual-input power source has two ports N1 and N2. N1 is a primary input port, and a power supply manner thereof is mains power. N2 is a backup input port, and a power supply manner thereof is generally in another power supply manner other than the mains power, for example, power supply by using a self-provided generator. When a plurality of dual-input power sources are disposed for the server or the cabinet, a primary power strip and a backup power strip are placed on opposite sides or a same side. As shown in FIG. 1b and FIG. 1c, it is assumed that there are three power sources. N1 of a power source 1 to a power source 3 is connected to a socket 1 (that is, the foregoing primary power strip) by power cables. N1 of the power module 1 to the power source 3 is connected to a socket 2 (that is, the foregoing backup power strip) by power cables. FIG. 1b shows that the socket 1 and the socket 2 are located on opposite sides, and FIG. 1c shows that the socket 1 and the socket 2 are located on a same side. Obviously, because N1 and N2 are alternately arranged, power cables of a plurality of power sources cross. This affects cables organized, and occupies at least 1U space of the cabinet.

In conclusion, when a plurality of dual-input power sources are disposed for the server or the cabinet, because there are a large quantity of power cables, cables organized becomes a major problem. An improper cables organized manner occupies space of the cabinet, and affects deployment and space utilization of the data center server.

To resolve the foregoing technical problem, the embodiments of the present invention propose to add a plurality of external power ports that are used to meet a cables organized requirement, to connect a plurality of power input ports of a plurality of power sources to the plurality of external power ports, so as to transform a structure (referred to as an initial structure for ease of description and differentiation), representing the plurality of power input ports, into a structure (referred to as a target structure for ease of description and differentiation) representing the plurality of external power ports. Subsequently, cabling is performed by the target structure to meet a cables organized requirement. It should be noted that, in the embodiments of the present invention, the external power ports are added to transform the initial structure, representing the plurality of power input ports. The structure mentioned in the embodiments of the present invention may be understood as an arrangement relationship between ports, that is, a sequence between the ports.

It should be noted that the initial structure is different from the target structure. Different structures herein may be understood as different arrangement relationships between ports. However, shapes formed by ports of the initial structure and shapes formed by ports of the target structure may be the same, for example, both are straight lines.

The following describes specific representation forms of the power input port and the external power port.

Specifically, the power input port and the external power port each include a plurality of wiring connection members. One wiring connection member is connected to one type of power cable. There are three types of power cables: a live wire, a neutral wire, and a ground wire. A current and a voltage provided by the live wire form a loop by the neutral wire for the current to pass through. The ground wire allows the current to flow directly into the earth when a circuit is short-circuited, so that safety can be ensured, to avoid a risk of electric shock. In actual application, the plurality of wiring connection members include at least a live-wire wiring connection member and a neutral-wire wiring connection member, and further, may further include a ground-wire wiring connection member.

For example, the power input port has only one live-wire wiring connection member, indicating single-phase electric power. A voltage between the live wire and the ground wire is 220 volts.

For example, the power input port may have three live-wire wiring connection members, indicating three-phase electric power. A voltage between each two live wires is 380 V.

It should be noted that quantities of wiring connection members of the power input port and the external power port are adapted to types of power cables connected to the wiring connection members. For example, the power input port has three wiring connection members that are respectively connected to the live wire, the neutral wire, and the ground wire. In this case, the external power port has three wiring connection members that are respectively connected to the live wire, the neutral wire, and the ground wire. The live-wire wiring connection members are connected to each other by the live wire, the neutral-wire wiring connection members are connected to each other by the neutral wire, and the ground-wire wiring connection members are connected to each other by the ground wire.

The following describes a specific type of the wiring connection member.

Type 1: The wiring connection member may include a screw and a clamping body. For example, a threaded hole is disposed on the clamping body, the power cable is placed on the clamping body, and the screw passes through the threaded hole to fasten the power cable between the clamping body and the screw. Alternatively, the power cable has a connector, the connector is provided with a through hole (for example, the connector is a circular metal piece having a through hole) or has an opening (for example, the connector is a U-shaped or Y-shaped metal piece), the connector is placed on the clamping body, and the screw passes through the connector and the threaded hole to fasten the connector between the clamping body and the screw, to implement connection to the power cable. For example, the clamping body may be a hollow metal cylinder. A threaded hole is disposed on the metal cylinder. The power cable is placed at a hollow location of the metal cylinder. The screw passes through the threaded hole to fasten the power cable at the hollow location of the clamping body.

Type 2: The wiring connection members can be a pluggable connection member such as a metal pin, a metal piece, or a metal post.

Type 3: The wiring connection body can be a socket hole.

For the power input port, the power input port may include a wiring connection member of any one of the foregoing type 1 to the foregoing type 3.

When the power input port includes a wiring connection member of the foregoing type 1, the power input port may be a terminal block formed by a plurality of wiring connection members. Herein, the terminal block is merely a name for ease of description and differentiation.

When the power input port includes a wiring connection member of the foregoing type 2, the power input port may be an external plug connector formed by a metal pin, a metal piece, a metal post, or the like, or a high-precision plug connector, and is generally referred to as a male connector. It should be noted that the external plug connector and the high-precision plug connector are merely names for ease of description and differentiation. In actual application, another name may be used. For example, the external plug connector may also be referred to as a first male connector, and the high-precision plug connector may also be referred to as a second male connector.

The external plug connector may be understood as a large-volume connector. For example, the external plug connector may be a connector C20 or C14 of an IEC 60320 power cable. The IEC 60320 power cable is a power cable that complies with the IEC 60320 international standard. Each type of connector of the IEC 60320 power cable is identified with the letter "C".

The high-precision plug connector may be understood as a small-volume connector, and may be connected to a PCB (Printed Circuit Board) in a power source. It should be noted that the PCB has a small volume, and correspondingly, the high-precision plug connector has a small volume. For example, a wiring connection member in the high-precision plug connector may be a PIN pin. Herein, a material of the PIN pin is "tungsten carbide", is cemented carbide with high hardness, strength, abrasion resistance, and corrosion resistance, and is referred to as "industrial tooth". The PIN pin is a high-precision product with a tolerance requirement ranging from ±0.001 to ±0.0005.

It should be noted that, in actual application, when the power input port and a power output port are on opposite sides, because space on a side on which the power input port is large, the power input port is generally an external plug connector. When the power input port and a power output port are on a same side, because space on a side of the power source is limited, the power input port is generally a high-precision plug connector to make full use of the space on the side of the power source.

When the power input port includes a wiring connection member of the foregoing type 3, the power input port may be an external socket-hole connector or a high-precision socket-hole connector, and is generally referred to as a female connector. It should be noted that the external socket-hole connector and the high-precision socket-hole connector are merely names for ease of description and differentiation. In actual application, another name may be used. For example, the external socket-hole connector may also be referred to as a first female connector, and the high-precision socket-hole connector may also be referred to as a second female connector.

The external socket-hole connector may be understood as a large-volume connector. For example, the external socket-hole connector may be a connector C19 or C13 of an IEC 60320 power cable.

For the external power port, the external power port may be an external plug connector or an external socket-hole connector. A side that is of the external power port and that is close to the power source is used to connect to the power input port, and a wiring connection member is disposed on a side that is of the external power port and that is away from the power source. The wiring connection member is used to connect to a socket. For ease of description and differentiation, it may be considered that the external power port includes an inner side and an outer side, and a wiring connection member is disposed on the outer side.

It should be noted that, in actual application, the wiring connection member on the outer side of the external power port and a socket port are connected by a power cable. A connector at one of two ends of the power cable is a plug connector, and is inserted into a socket hole of the socket. A connector at the other of two ends of the power cable is adaptively connected to the wiring connection member on the outer side of the external power port.

For example, if the wiring connection member disposed on the outer side of the external power port forms C14, and the socket hole on the socket is C13, two connectors of the power cable are C13 and C14.

For example, if the wiring connection member disposed on the outer side of the external power port forms C19, and the socket hole on the socket is C19, two connectors of the power cable are both C20.

The following describes a connection manner between the external power port and the power input port.

In a feasible implementation, the external power port and the power input port may be connected to each other by a power cable.

In an example, the wiring connection member in the power input port is a wiring connection member of the foregoing type 1, and a power cable is connected to the inner side of the external power port. For example, there is no connector at an end that is of the power cable and that is away from the external power port, and a screw passes through a threaded hole to fasten the power cable between a clamping body and the screw. For example, there is a connector at an end that is of the power cable and that is away from the external power port, and a screw passes through the connector and a threaded hole to fasten the connector between a clamping body and the screw, to implement connection to the power cable.

In an example, the wiring connection members in the power input port is a wiring connection member of the foregoing type 2 or type 3, and a power cable is connected to the inner side of the external power port. There is a connector adapted to the power input port at an end that is of the power cable and that is away from the external power port. In this case, the connector of the power cable is inserted into the power input port. Herein, the external power port is equivalent to a connector on the power cable.

It should be noted that the wiring connection member of the foregoing type 1 can be disposed on the inner side of the external power port, to connect to the power cable by the wiring connection member.

In a feasible implementation, the external power port and the power input port may be connected to each other by a power conversion board. Herein, the power conversion board may be a PCB.

In an example, a plurality of wiring holes of the external power port are disposed on the power conversion board, and a plurality of Plug connectors i adapted to the plurality of wiring holes are disposed on the inner side (a side close to the power conversion board) of the external power port, to connect the external power port to the power conversion board by inserting the plurality of insertion members into the plurality of wiring holes on the power conversion board.

Herein, a quantity of wiring holes is the same as a quantity of wiring connection members in the external power port. In other words, the plurality of wiring holes include at least a live-wire wiring hole and a neutral-wire wiring hole, and further include a ground-wire wiring hole. It should be noted that the insertion member and the wiring connection member herein are different, and an insertion member and a wiring connection member of a same type of power cable are connected to each other.

In an example, a plurality of wiring holes of the power input port are disposed on the power conversion board. For the plurality of wiring holes, refer to the foregoing descriptions.

For example, the power input port is a terminal block. In this case, the power input port is connected to the power cable in the foregoing manner. A plurality of insertion members adapted to the plurality of wiring holes are disposed at an end of the power cable, and the plurality of insertion members are inserted into the plurality of wiring holes on the power conversion board, to implement connection.

For example, the power input port is an external plug connector or an external socket-hole connector. In this case, the power input port is connected to a first connector, a plurality of insertion members adapted to the plurality of wiring holes are disposed on the first connector, and the plurality of insertion members are inserted into the plurality of wiring holes on the power conversion board to connect the power input port to the power conversion board. The embodiments of the present invention are not intended to impose any limitation on a structure of the first connector. Herein, "first" in the first connector has no specific meaning, and is merely for ease of description and differentiation.

For example, the power input port may be a high-precision plug connector or a high-precision socket-hole connector. In this case, the power input port is connected to a second connector, a plurality of insertion members adapted to the plurality of wiring holes are disposed on the second connector, and the plurality of insertion members are inserted into the plurality of wiring holes on the power conversion board to connect the power input port to the power conversion board. The embodiments of the present invention are not intended to impose any limitation on a structure of the second connector. Herein, "second" in the second connector has no specific meaning, and is merely for ease of description and differentiation.

It should be noted that the foregoing connection manner between the external power port and the power input port is merely an example, and imposes no specific limitation.

In actual application, all the power input ports may include any one or more of a terminal block, an external plug connector, an external socket-hole connector, a high-precision plug connector, and a high-precision socket-hole connector. Preferably, all the power input ports include one of the foregoing connectors. For example, all the power input ports are external plug connectors. For another example, all the power input ports are external socket-hole connectors.

The foregoing related descriptions of the external power port and the power input port are merely examples, and impose no specific limitation.

In addition, in the embodiments of the present invention, cables organized problem needs to be resolved. Therefore, the target structure may be used to at least connect to a plurality of sockets without cross-cabling, to supply power to a plurality of power sources by the plurality of sockets.

It should be noted that, generally, power specifications and power supply manners of power ports on a same socket are the same. Therefore, a plurality of external power ports that need to be connected to power input ports having a same power specification and a same power supply manner may be used as one port group, and an arrangement relationship is designed based on the port group, to form the target structure. Further, external power ports in a same port group are connected to one socket, and the socket is connected to a power source. Herein, the external power ports in the port group are flexibly arranged, and can be flexibly disposed based on an actual situation, so that no cross-cabling is implemented.

It should be noted that, in actual application, when a quantity of external power ports in the port group is less than or equal to a quantity of socket holes in a single socket, all the external power ports in the port group are connected to one socket. When a quantity of external power ports in the port group is greater than a quantity of socket holes in a single socket and is less than the quantity of external power interfaces in the interface group, the external power ports in the port group are connected to a plurality of sockets. These sockets may be disposed on a same side to avoid cross-cabling. A disposition location of the socket is not specifically limited in the embodiments of the present invention, and may be specifically determined based on an actual requirement. In actual application, the plurality of sockets may be disposed on any side of a plurality of power sources such as a left side, a right side, an upper side, a lower side, and a rear side. Alternatively, the plurality of sockets may be disposed on opposite sides such as a left side and a right side, and an upper side and a lower side of a plurality of power sources. This is not specifically limited in the embodiments of the present invention, and may be specifically determined based on an actual requirement.

The port group can be divided based on power specifications and power supply manners of power input ports of the plurality of power sources. Generally, external power ports corresponding to power input ports that are of the plurality of power sources and that have a same power specification and a same power supply manner are used as an port group. To facilitate understanding of the technical solutions provided in the embodiments of the present invention, the following describes in detail the power input ports of the plurality of power sources.

Specifically, there may be a plurality of types of power input ports based on different power supply manners or different power specifications.

For example, there may be two power supply manners, one is a primary power supply manner, and the other is a backup power supply manner. When the primary power supply manner is available, power is supplied in the primary power supply manner. When the primary power supply manner is powered off, power is supplied in the backup power supply manner. In actual application, a power source in the primary power supply manner is generally mains power, and a power source in the backup power supply manner is generally a backup power source. In actual application, one power input port is connected to a socket of the mains power, another power input port is connected to a socket of the backup power source, and power input ports in different power supply manners need to be connected to different sockets.

For example, the power specification may vary with a voltage that needs to be input. For example, when the voltage that needs to be input is 220 V, the power specification is 220 V. When the voltage that needs to be input is 380 V, the power specification is 380 V.

In other words, when power supply manners and power specifications of two power input ports are the same, it indicates that the two power input ports are of a same type. When either power supply manners or power specifications of two power input ports are different, it indicates that the two power input ports are of different types.

One power source may include only one power input port, or one power source includes A power input ports, where A is greater than or equal to 2. The A power input ports may include only one type of power input port, or may include at least two types, where each type of power input port includes at least one port.

For example, in some embodiments, one power source may include two power input ports, where the two power input ports include two different types; one type is in the primary power supply manner, and the input voltage is 220 V; and the other type is in the backup power supply manner, and the input voltage is 220 V.

In some other embodiments, one power source may include three power input ports, where the three power input ports include three different types; the first type is in the primary power supply manner, and the input voltage is 220 V; the second type is in the primary power supply manner, and the input voltage is 380 V; and the third type is in the backup power supply manner, and the input voltage t is 220 V.

In some other embodiments, one power source may include three power input ports, where the three power input ports include two different types; the first type and the second type are the same, are both in the primary power supply manner, and the input voltage is 220 V; and the third type is in the backup power supply manner, and the input voltage is 220 V.

In other words, when quantities and types of power input ports of two power sources are the same, it indicates that the two power sources are of a same type. When either quantities or types of power input ports of two power sources are different, it indicates that the two power sources are of different types.

Further, in actual application, one server may include a plurality of power sources. These power sources may be of a same type, or may include at least two types. Each type of power source includes at least one power source. For example, one server includes a plurality of power sources of a same type (which may be referred to as target power sources in some possible implementations), and m power input ports are disposed for each power source, correspond to a same power specification but different power supply manners, and correspond to a total of m power supply manners, denoted as powermode-1, ..., and power mode-m. In this case, m port groups of external power ports may be disposed, and are denoted as con-1, ..., con-m. The m port groups are in one-to-one correspondence with the m power supply manners. It is assumed that power mode-i corresponds to con-i, where i=1, 2, ..., m. In this case, for an port group con-i, a plurality of external power ports forming the port group are connected to power input ports that are of the plurality of power sources and that are respectively in the power supply manner power mode-i. In actual application, if a quantity of power sources is large, the plurality of external power ports of the port group may be connected to a plurality of sockets, to meet an actual requirement.

For example, one server includes a plurality of power sources, and the plurality of power sources include two types of power sources. Specifically, the plurality of power sources include n1 first power sources and n2 second power sources. Respective power input ports in two power supply manners are disposed for each of the n1 first power sources. Respective power input ports in three other power supply manners are disposed for each of the n2 second power sources. In this case, five port groups of external power ports may be disposed, and are respectively n11, n12, n21, n22, and n23. Power input ports that are of the n1 power sources and that are in a first power supply manner may be connected to the port group n11. Power input ports that are of the n1 power sources and that are in a second power supply manner may be connected to the port group n12. Power input ports that are of the n2 power sources and that are in a first power supply manner may be connected to the port group n21. Power input ports that are of the n2 power sources and that are in a second power supply manner may be connected to the port group n22. Power input ports that are of the n2 power sources and that are in a third power supply manner may be connected to the port group n23. When the port group n11, the port group n12, the port group n21, the port group n22, and the port group n23 are connected to sockets through cabling outside the housing, no cross-cabling occurs.

For example, the plurality of power sources include n1 first power sources and n2 second power sources, Respective power input ports in a power supply manner 1 and a power supply manner 2 are disposed for each of the n1 first power sources, and Respective power input ports in the power supply manner 1, the power supply manner 2, and a power supply manner 3 are disposed for each of the n2 second power sources. In this case, three port groups of external power ports may be disposed, and are respectively n11, n12, and n23. Power input ports that are of the n1 power sources and the n2 power sources and that are in the power supply manner 1 may be connected to the port group n11. Power input ports that are of the n1 power sources and the n2 power sources and that are in the power supply manner 2 may be connected to the port group n12. Power input ports that are of the n2 power sources and that are in the power supply manner 3 may be connected to the port group n23. When the port group n11, the port group n12, and the port group n23 are connected to sockets through cabling outside the housing, no cross-cabling occurs.

Based on the foregoing technical solutions, an embodiment of the present invention provides a first type of electronic device.

An electronic device includes: N power sources, where a plurality of power input ports are disposed for each power source, and M power input ports are disposed for the N power sources in total; and a connection module, including M external power ports, where the M external power ports are located on an outer surface of a housing, and the N power sources are disposed inside the housing. Herein, both N and M are positive integers greater than or equal to 2.

Further, the M external power ports are connected to the M power input ports inside the housing in a one-to-one correspondence with cross-cabling, so that an initial structure representing the M power input ports is transformed into a target structure representing the M external power ports on the housing.

It should be noted that, in some possible implementations, the external power port may be referred to as a first power port, the initial structure may be referred to as a first structure, the target structure may be referred to as a second structure, and M may be referred to as a target quantity. Herein, "first" and "second" have no special meaning, and are merely for ease of description and differentiation. In addition, it should be understood that, each external power port runs through the housing, and a wiring connection member is disposed on a side that is of the external power port and that is away from the power source, to implement external connection. It should be further noted that the N power sources may be from a same manufacturer or different manufacturers, and are preferably from a same manufacturer.

In this solution, for the N power sources, the M external power ports are adaptively added, thereby transforming the initial structure of the M power input ports. In addition, the power input port is no longer limited by layout of the power source. Therefore, the target structure of the M external power ports on the outer surface of the housing may be flexibly designed based on an actual cables organized requirement, thereby reducing cables organized difficulty, and avoiding cross-cabling between the external power ports. Moreover, connection is performed through cabling inside the electronic device, to implement structure transformation, so that no external space of the electronic device is occupied. Furthermore, the power input port is no longer limited by layout of the power source. Therefore, in this embodiment of the present invention, a quantity of power sources is not limited, and the quantity of power sources may be set based on an actual requirement.

It should be understood that the target structure includes a plurality of sub-structures, and there is no cross and overlapping relationship between areas respectively occupied by the sub-structures on the housing. In other words, no external power port of another sub-structure exists in an area in which any sub-structure is located, so that different sub-structures can be connected to sockets without cross-cabling. It should be noted that, for ease of description and differentiation, the sub-structure may also be referred to as a third structure. Certainly, the sub-structure may be understood as a structure representing the foregoing port group. It should be noted that an arrangement manner and a shape of the external power port in the sub-structure may be randomly set. Herein, the area in which the sub-structure is located may be understood as an enclosed area occupied by the sub-structure, and is generally an enclosed area formed after edges of the sub-structure are directly connected.

For example, the electronic device includes N same power sources, and a plurality of power input ports having a same power specification but different power supply manners are disposed for each power source. In a specific implementation, for any power supply manner, N external power ports in the power supply manner are respectively in a one-to-one correspondence with N power input ports in the power supply manner, and are connected to each other through cabling inside the electronic device, so that no external space of the electronic device is occupied. In addition, for any power supply manner, N external power ports in the power supply manner are used as one port group, a structure representing the one port group is used as a sub-structure, and it is designed that sub-structures in different power supply manners do not cross and overlap, so that the N external power ports in different power supply manners do not cross during cabling outside the housing, thereby avoiding cross-cabling. In a possible implementation, the foregoing power supply manner may be replaced with the power specification. In this case, for any power source in the N power sources, the power source is used to convert a plurality of power specifications into available power specifications of the electronic device, and respective input power specifications of the plurality of disposed power input ports are different.

For example, the N power sources include m power sources (referred to as target power sources for ease of description and differentiation). At least two power input ports are disposed for each target power source. The at least two power input ports include a power input port (referred to as a first-type power input port for ease of description and differentiation) whose power supply manner is a primary power supply manner and a power input port (referred to as a second-type power input port for ease of description and differentiation) whose power supply manner is a backup power supply manner. The plurality of sub-structures include a primary power supply structure and a backup power supply structure. The primary power supply structure is connected to the first-type power input port, and the backup power supply structure is connected to the second-type power input port. Herein, m may be equal to N, or may be less than N. Power specifications of the first-type power input port and the first-type power input port may be the same or different, and are preferably the same. The M power sources may be of a same type or different types, and are preferably of a same type. In addition, this embodiment of the present invention is not intended to limit a relative location relationship between the power source and the external power port. In actual application, whether a location of the external power port is limited by a location of the power source specifically needs to depend on connection between the external power port and the power source. If the external power port is connected to the power source in a manner in which deformation cannot be flexibly performed, for example, by a power conversion board, the external power port is limited by the location of the power source, and the external power port and the power input port are generally in a same horizontal plane. If the external power port is connected to the power source by an object that can be flexibly deformed, for example, a power cable, a location relationship between the external power port and the power input port is not required. Optionally, the location of the external power port does not correspond to the location of the power source. In other words, a location of an orthographic projection of the power source on the housing is different from the location of the external power port. Correspondingly, the location of the external power port is not limited by the location of the power source. Optionally, the location of the external power port corresponds to the location of the power source. In other words, a location of an orthographic projection of the power source on the housing overlaps the location of the external power port. Correspondingly, the location of the external power port may be limited by the location of the power source, or may not be limited by the location of the power source.

In addition, the target structure provided in this embodiment of the present invention is connected to a plurality of sockets without cross-cabling, and the plurality of sockets may be flexibly disposed on one or both sides of the power consumption device.

To better describe the technical solutions provided in this embodiment of the present invention, with reference to FIG. 2, the following describes the technical solutions provided in this embodiment of the present invention. FIG. 2 is an example diagram 1 of connecting a power source to a connection module according to an embodiment of the present invention.

As shown in FIG. 2, a total of three power sources are disposed inside the electronic device, two power input ports N11 and N12 are disposed for a power source 1, two power input ports N21 and N22 are disposed for a power source 2, two power input ports N31 and N32 are disposed for a power source 3, and six power input ports are disposed in the total. The three power input ports N11, N21, and N31 are of a same type, and may be connected to one socket (referred to as a socket 1 for ease of description and differentiation). The three power input ports N12, N22, and N32 are of a same type, and may be connected to another socket (referred to as a socket 2 for ease of description and differentiation).

In an example, the power source 1, the power source 2, and the power source 3 are the same, and the two power input ports disposed for each power source have a same power specification but different power supply manners. Power supply manners of N11, N21, and N31 are the same, and are the primary power supply manner. Power supply manners of N12, N22, and N32 are the same, and are the backup power supply manner. Because the power supply manners are different, the socket 1 to which the power input ports N11, N21, and N31 are connected is a primary power supply socket, and the socket 2 to which the power input ports N12, N22, and N32 are connected is a backup power supply socket.

In an example, the power source 1, the power source 2, and the power source 3 are the same, and the two power input ports disposed for each power source have different power specifications. Power specifications of N11, N21, and N31 are the same, and power specifications of N12, N22, and N32 are the same. Because the power specifications are different, the power input ports N11, N21 and N31 need to be connected to one power strip, and the power input ports N12, N22 and N32 need to be connected to another power strip.

Correspondingly, as shown in FIG. 2, a connection module C includes six external power ports F11, F21, F31, F12, F22, and F32. F11, F21, F31, F12, F22, and F32 are respectively connected to N11, N21, N31, N12, N22, and N32 in a one-to-one correspondence with cross-cabling, to transform an initial structure of N11, N12, N21, N22, N31, and N32 into a target structure of F11, F21, F31, F12, F22, and F32.

F11, F21, and F31 are used as one port group, F12, F22, and F32 are used as another port group, and the two port groups are arranged side by side, so that the two port groups can be connected to different sockets without cross-cabling.

It should be noted that because F11, F21, and F31 are the same and are adapted to N11, N11 may be connected to any one of F11, F21, and F31. N11, N21, and N31 are the same. Therefore, N21 and N31 may also be connected to any one of F11, F21, and F31. In this embodiment of the present invention, it is only necessary to ensure that N11, N21, and N31 each correspond to one external power port, and a correspondence between F11, F21, and F31, and N11, N21, and N31 is not fixed, and may be flexibly set based on a requirement. F12, F22, and F32, and N12, N22, and N32 are similar to the foregoing ports, and details are not described again.

It should be noted that FIG. 2 shows a path in which F11, F21, F31, F12, F22, and F32 are connected to N11, N21, N31, N12, N22, and N32. The connection manner is merely an example, and imposes no specific limitation.

The following describes a connection manner between the external power port and the power input port.

In a feasible implementation, as shown in FIG. 2, the external power port and the power input port are connected to each other by a power cable.

In actual application, the power input port includes a wiring connection member of the foregoing type 1, and the external power port is equivalent to a connector of the power cable.

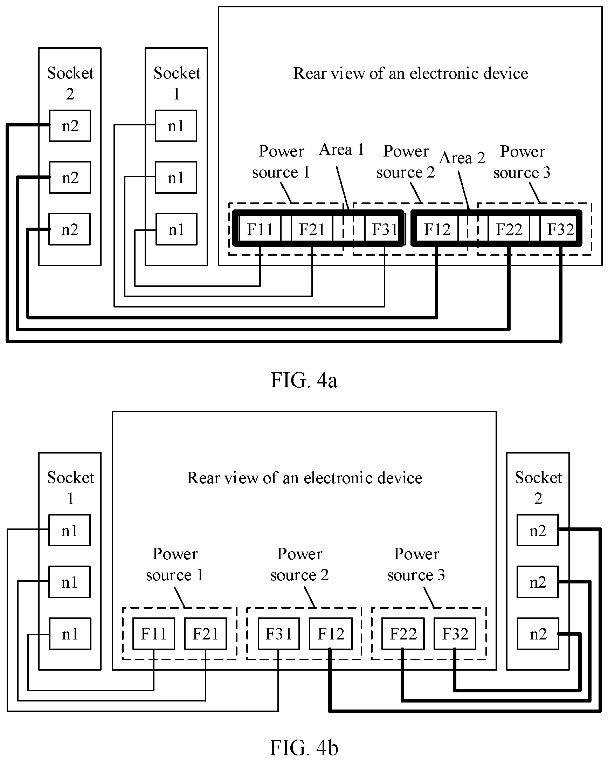

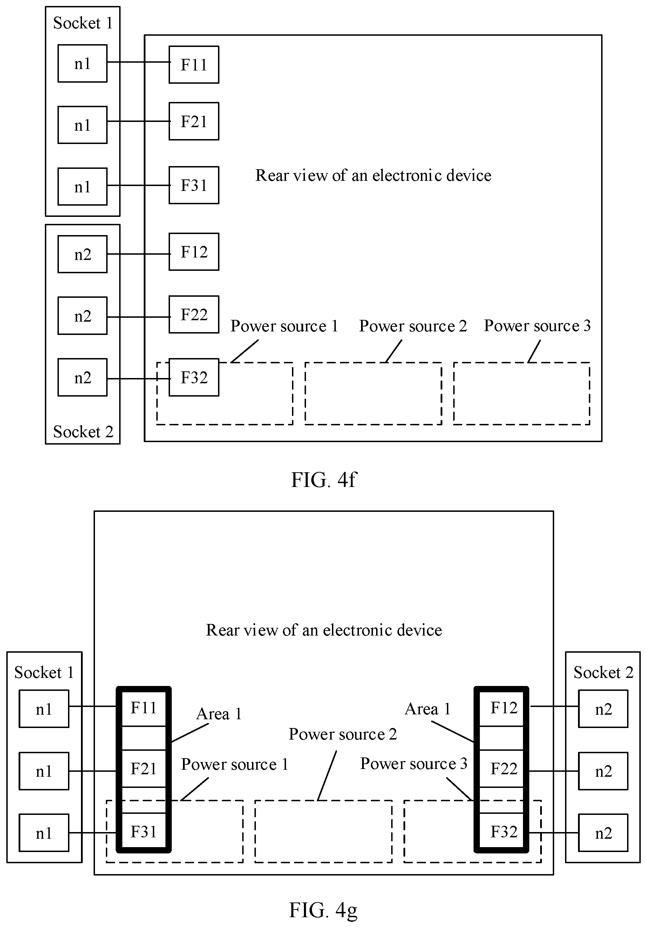

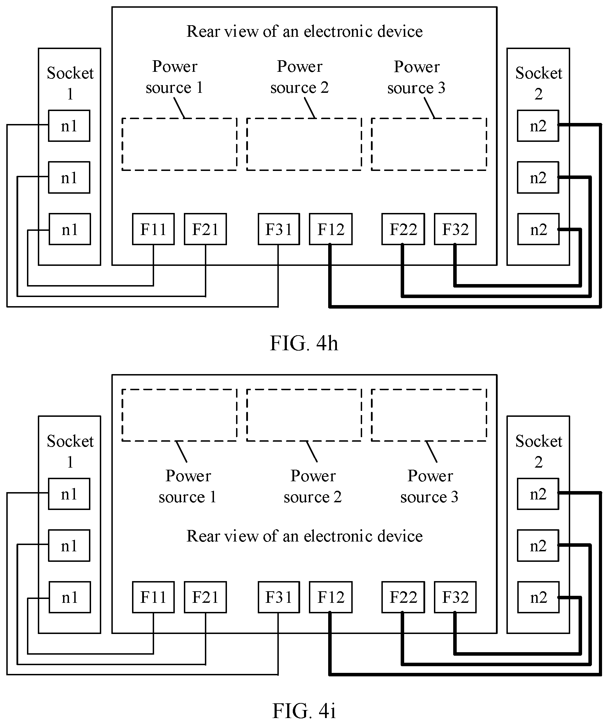

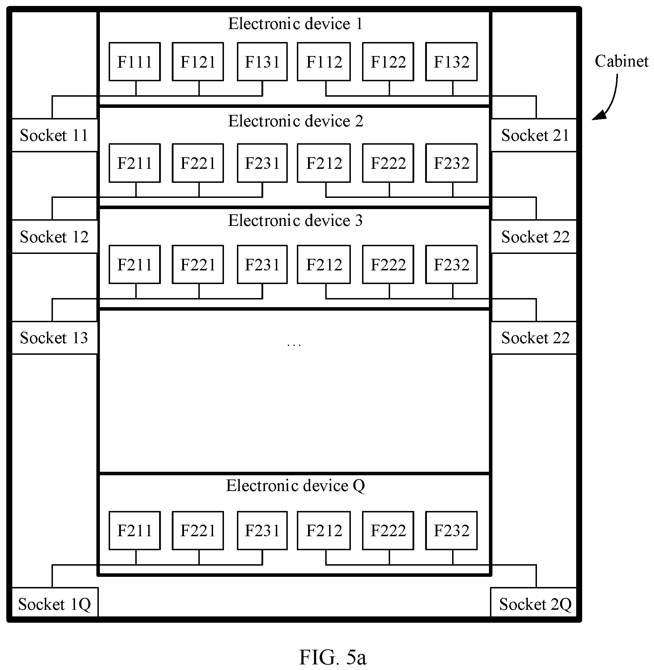

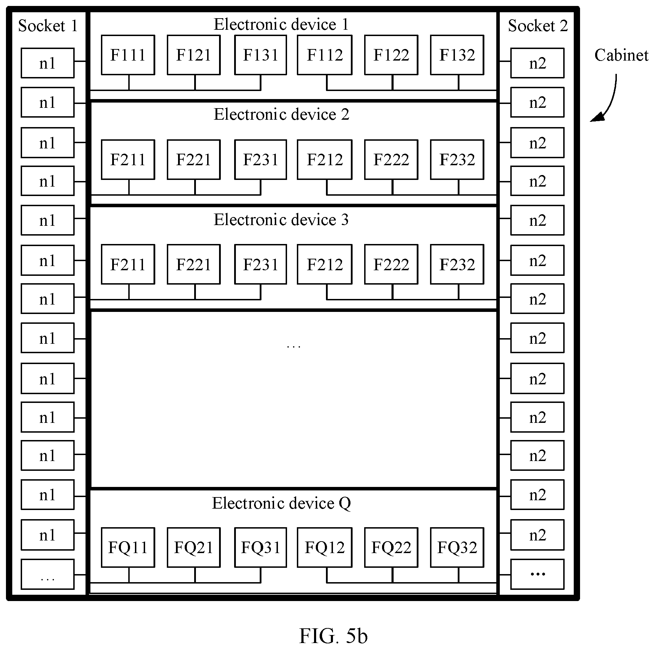

Herein, the structure of the six external power ports is not limited by a location of the power source, and the power cable does not limit a location of the external power port. Therefore, when it is ensured that power cables connecting the external power ports to sockets do not cross, a shape formed by the target structure representing the external power ports may be designed based on a specific requirement. For example, the external power ports may be arranged into a straight line, a matrix, a circle, or an arc shape. This is not specifically limited in this embodiment of the present invention. For example, as shown in FIG. 4a to FIG. 4e, FIG. 4f, FIG. 4h, and FIG. 4i, shapes formed by the six external power ports F11, F21, F31, F12, F22, and F32 are straight lines. As shown in FIG. 5b, a shape formed by the three external power ports F11, F21, and F31 is a straight line, a shape formed by F12, F22, and F32 is a straight line, and the two straight lines are parallel to each other.

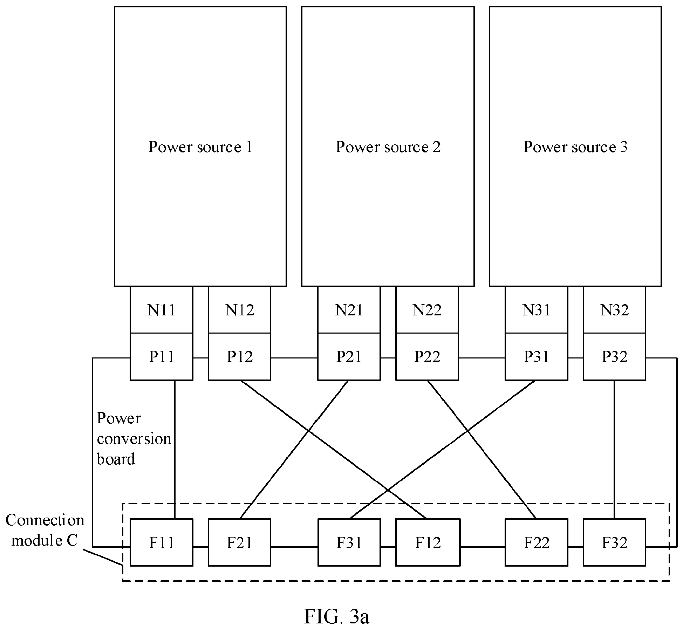

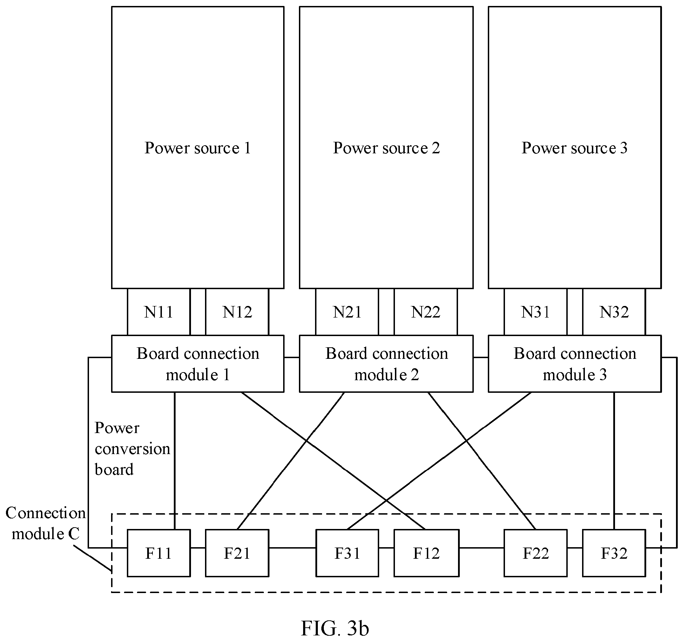

In some other embodiments, the external power port and the power input port may be connected to each other by a power conversion board. FIG. 3a and FIG. 3b are an example diagram 2 and an example diagram 3 of connecting a power source to a connection module according to an embodiment of the present invention. In a feasible implementation, as shown in FIG. 3a and FIG. 3b, the foregoing six external power ports and the foregoing six power input ports are connected to each other by a power conversion board.

In an example, as shown in FIG. 3a, six ports adapted to the six external power ports are disposed on a side that is of the power conversion board and that is away from the three power sources, so that the six external power ports F11, F21, F31, F12, F22, and F32 are connected to the power conversion board. Six ports adapted to six connectors are disposed on a side that is of the power conversion board and that is close to the three power sources, so that the six power input ports N11, N21, N31, N12, N22 and N32 are connected to the power conversion board by the connectors.

In an example, as shown in FIG. 3b, three board connection module ports are disposed on a side that is of the power conversion board and that is away from the three power sources, the three board connection module ports are each connected to one board connection module, and one board connection module is connected to two power input ports disposed for one power source, so that the three power sources are connected by the three board connection modules to the side that is of the power conversion board and that is away from the two power sources. Specifically, the two power input ports N11 and N12 of the power source 1 are connected to the power conversion board by a board connection module 1, the two power input ports N21 and N22 of the power source 2 are connected to the power conversion board by a board connection module 2, and the two power input ports N31 and N32 of the power source 3 are connected to the power conversion board by a board connection module 1. It should be noted that, in this example, power specifications of the two power input ports of the power source are the same. Optionally, when the two power input ports of the power source are designed as high-precision plug connectors or high-precision socket-hole connectors, the power input port and the external power port may be connected to each other in the manner shown in FIG. 3b.

In this implementation, a location of the external power port is limited by a location of the power source and a location of the power conversion board. More specifically, a shape formed by the external power port is limited by a form of the power conversion board, and is generally a straight line. The location of the external power port is limited by the location of the power source.

The following describes the locations of the external power port and the power source shown in FIG. 2.

FIG. 4a to FIG. 4i are a schematic diagram 2 to a schematic diagram 9 of connecting an external power port to a socket according to an embodiment of the present invention, and show a location relationship between the foregoing six external power ports and the three power sources.

As shown in FIG. 4a, the power sources are disposed at a lower part of the electronic device, and the six external power ports F11, F21, F31, F12, F22, and F32 are disposed at the lower part of the electronic device, to form a shape of a straight line.

As shown in FIG. 4b, the power sources are disposed at a lower part of the electronic device, and the six external power ports F11, F21, F31, F12, F22, and F32 are disposed at the lower part of the electronic device, to form a shape of a straight line.

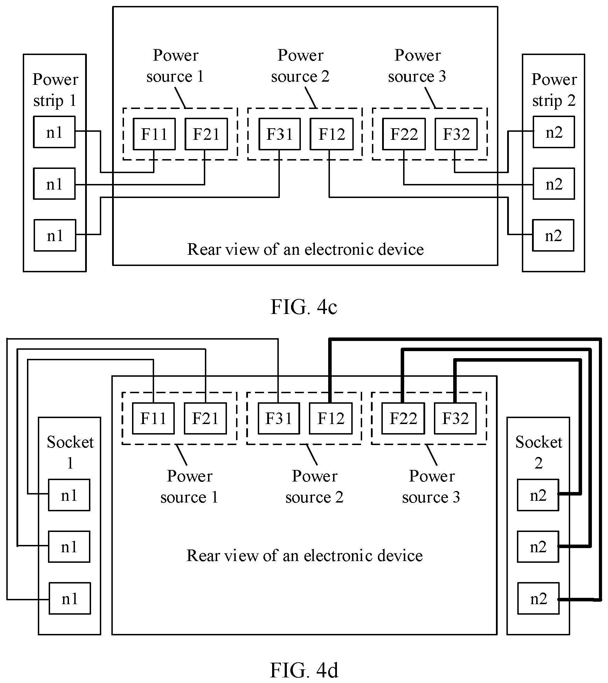

As shown in FIG. 4c, the power sources are disposed at a middle part of the electronic device, and the six external power ports F11, F21, F31, F12, F22, and F32 are disposed at the middle part of the electronic device, to form a shape of a straight line.

As shown in FIG. 4d, the power sources are disposed at an upper part of the electronic device, and the six external power ports F11, F21, F31, F12, F22, and F32 are disposed at the upper part of the electronic device, to form a shape of a straight line.

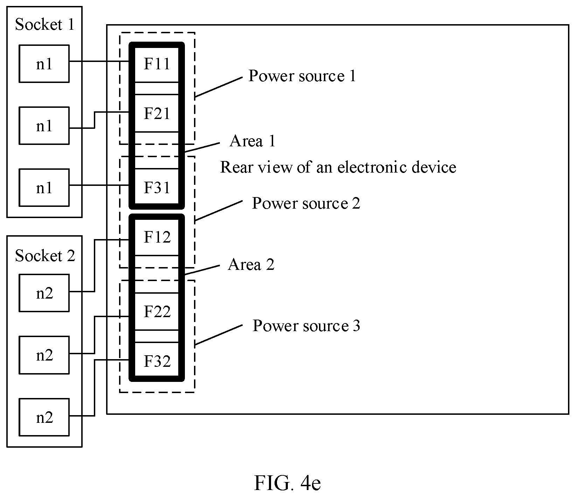

As shown in FIG. 4e, the power sources are disposed on a left side of the electronic device, and the six external power ports F11, F21, F31, F12, F22, and F32 are disposed on the left side of the electronic device, to form a shape of a straight line.

Herein, locations of the external power port on the housing shown in FIG. 4a to FIG. 4e correspond to locations of the power input ports of the power sources, and the connection manners shown in FIG. 2, FIG. 3a, and FIG. 3b may be used.

As shown in FIG. 4f, the power sources are disposed at a lower part of the electronic device, and the six external power ports F11, F21, F31, F12, F22, and F32 are disposed on a left side of the electronic device.

As shown in FIG. 4g, the power sources are disposed at a lower part of the electronic device, three external power ports F11, F21, and F31 are disposed on a left side of the electronic device, and three external power ports F12, F22, and F32 are disposed on a right side of the electronic device.

As shown in FIG. 4h, the power sources are disposed at a middle part of the electronic device, and the six external power ports F11, F21, F31, F12, F22, and F32 are disposed at a lower part of the electronic device.

As shown in FIG. 4i, the power sources are disposed at an upper part of the electronic device, and the six external power ports F11, F21, F31, F12, F22, and F32 are disposed at a lower part of the electronic device.

Herein, locations of the external power port on the housing shown in FIG. 4f to FIG. 4i do not correspond to locations the power input ports of the power sources, and the connection manner shown in FIG. 2 may be used.

In a feasible implementation, the six external power ports shown in FIG. 2 are of two sub-structures, the three external power ports F11, F21, and F31 are of one sub-structure con-1, the sub-structure con-1 occupies an area 1 on the housing, F12, F22, and F32 are of another sub-structure con-2, and the sub-structure con-2 occupies an area 2 on the housing. There is no cross and overlapping relationship between the areas occupied by the sub-structure con-1 and the sub-structure con-2. In this way, three power cables for F11, F21, and F31 connecting to the socket 1 and three power cables for F12, F22, and F32 connecting to the socket 2 do not cross.

For example, the three external power ports F11, F21, and F31 in FIG. 4a, FIG. 4e, and FIG. 4g are of one sub-structure, the sub-structure occupies an area 1, F12, F22, and F32 are of another sub-structure, and the sub-structure occupies an area 2. Because no external power port in the another sub-structure exists in the area 1, no cross-cabling is implemented.

Further, as shown in any one of FIG. 4a to FIG. 4i, the sub-structure con-1 is connected to the socket 1, the socket 1 is a primary power supply socket, the sub-structure 2 is connected to the socket 2, and the socket 2 is a backup power supply socket.

In an example, as shown in FIG. 4a, the socket 1 and the socket 2 to which the six external power ports shown in FIG. 2 are connected are disposed on a same side of the power consumption device.

In an example, as shown in any one of FIG. 4a to FIG. 4c and FIG. 4g to FIG. 4i, the socket 1 and the socket 2 to which the six external power ports shown in FIG. 2 are connected are disposed on the left side and the right side of the power consumption device.

The following describes in detail specific application of the target structure and the socket.

Scenario 1: The electronic device is disposed in a cabinet, and the cabinet is configured to accommodate a plurality of electronic devices and a plurality of sockets. The plurality of electronic devices may be arranged into one column, or may be arranged into a plurality of columns. This is not specifically limited in this embodiment of the present invention, and may be specifically determined based on an actual requirement. For example, one electronic device may be one server. For example, a plurality of electronic devices may be located in one server. This embodiment of the present invention is not intended to limit a quantity of electronic devices in the server. If the server requires a large quantity of power sources, the server may include a plurality of electronic devices. The quantity of electronic devices is increased, so that the quantity of power sources in the server is increased.

For ease of description, a vector that starts at a center point of the electronic device, that is perpendicular to a bottom surface of the cabinet, and that extends away from the bottom surface of the cabinet is constructed, and a direction is described by using the vector as a reference line. For ease of description, inner surfaces of the housing on left, right, upper, lower, front, and rear sides of the reference line are referred to as a left inner surface, a right inner surface, an upper inner surface, a lower inner surface, a front inner surface, and a rear inner surface.

For example, the sockets may be disposed on the left side of the electronic device. Specifically, two parallel connection brackets are disposed on the left side of the electronic device, and the two parallel connection brackets are used to mount one or more sockets, so that the sockets are mounted on the left side of the electronic device. For example, two connection brackets are disposed on the left inner surface, the front inner surface, and the rear inner surface, or the upper inner surface and the lower inner surface. In addition, when the two connection brackets are perpendicular to the bottom surface of the cabinet, the sockets are horizontally disposed, that is, the sockets are parallel to the bottom surface of the cabinet. When the two connection brackets are parallel to the bottom surface of the cabinet, the sockets are vertically disposed, that is, the sockets are perpendicular to the bottom surface of the cabinet.

For example, the sockets may be disposed on the right, upper, lower, and rear sides of the electronic device. For details, refer to the content that the sockets are disposed on the left side of the electronic device. Details are not described again.

In actual application, the plurality of sockets may be disposed on any side of the electronic device such as the left side, the right side, the upper side, the lower side, and the rear side. Alternatively, the plurality of sockets may be disposed on opposite sides of the electronic device such as the left side and the right side, and the upper side and the lower side. The plurality of sockets may be horizontally or vertically disposed. This is not specifically limited in this embodiment of the present invention, and may be specifically determined based on an actual requirement. It should be noted that, if a sub-structure needs to be connected to a plurality of sockets, the plurality of sockets need to be disposed on a same side to avoid cross-cabling.

Correspondingly, a plurality of sockets are disposed in the cabinet. Herein, the socket may be a PDU (Power Distribution Unit, power distribution unit). A target structure of the plurality of electronic devices in the cabinet is connected to the plurality of sockets without cross-cabling, to supply power to each power source of the plurality of electronic devices in the cabinet by the plurality of sockets.

FIG. 5a to FIG. 5c are a schematic diagram 1 to a schematic diagram 3 of connecting external power ports of a plurality of electronic devices in a cabinet to a plurality of sockets in the cabinet according to an embodiment of the present invention.

As shown in FIG. 5a and FIG. 5b, Q electronic devices are disposed in the cabinet, and are denoted as an electronic device 1, an electronic device 2, ..., and an electronic device Q. Three power sources are disposed for each electronic device, two power input ports are disposed for each power source, and correspondingly, six external power ports are disposed. Six external power ports of an electronic device i are denoted as Fi11, Fi21, Fi31, Fi12, Fi22, and Fi32. Fi11 represents the first external power port of the first power source of the electronic device i, and Fi21 represents the second external power port of the first power source of the electronic device i. Fi31, Fi12, Fi22, and Fi32 are similar, and details are not described again.

It is assumed that the external power ports Fi11, Fi21, and Fi31 of the electronic device i are connected to one power strip, and the external power interfaces Fi11, Fi21, and Fi31 are connected to another power strip.

As shown in FIG. 5a, each of the Q electronic devices is connected to two sockets, and a total of 2*Q sockets are connected. The 2*Q sockets are horizontally disposed inside the cabinet, and are located on left and right sides of the Q electronic devices. Q sockets disposed on the left side of the Q electronic devices are denoted as a socket 11, a socket 12, ..., and a socket 1Q. Q sockets disposed on the right side of the Q electronic devices are denoted as a socket 21, a socket 22, ..., and a socket 2Q. The external power ports Fi11, Fi21 and Fi31 of the electronic device i are connected to a socket 1i, and the external power ports Fi12, Fi22 and Fi32 are connected to a socket 2i, where i=1, 2, ..., Q. FIG. 5a is merely an example, and imposes no specific limitation. In actual application, the 2*Q sockets may be disposed on the left side or the right side of the Q electronic devices, or may be disposed on a rear side thereof. In addition, the foregoing implementation is applied to a scenario in which power sources disposed for the Q electronic devices are the same, for example, the electronic device in FIG. 2, and is also applied to a scenario in which power sources of the Q electronic devices are of different types, for example, power specifications corresponding to the three power sources of the electronic device 1 are different from power specifications corresponding to the three power sources of the electronic device 2.

It is assumed that a quantity of external power ports of the Q electronic devices is not particularly large, the Q electronic devices are the same, the three power sources disposed for each electronic device are the same, and the two power input ports disposed for each of the three power sources need to be connected to different sockets. In this case, two sockets may be disposed for the Q electronic devices, and are denoted as a socket 1 and a socket 2. For example, the socket 1 may be a primary power supply socket, and the socket 2 may be a backup power supply socket. As shown in FIG. 5b, the socket 1 and the socket 2 are vertically disposed inside the cabinet, and are located on a left side and a right side of the Q electronic devices. The socket 1 is disposed on the left side of the Q electronic devices, and the socket 2 is disposed on the right side of the Q electronic devices. F111, F121, F131, F211, F221, F231, ..., FQ11, FQ21, and FQ31 are connected to the socket 1, and F112, F122, F132, F212, F222, F232, ..., FQ12, FQ22, and FQ32 are connected to the socket 2. FIG. 5b is merely an example, and imposes no specific limitation. In actual application, the socket 1 and the socket 2 may be disposed on the left side or the right side of the Q electronic devices, or may be disposed on a rear side thereof.

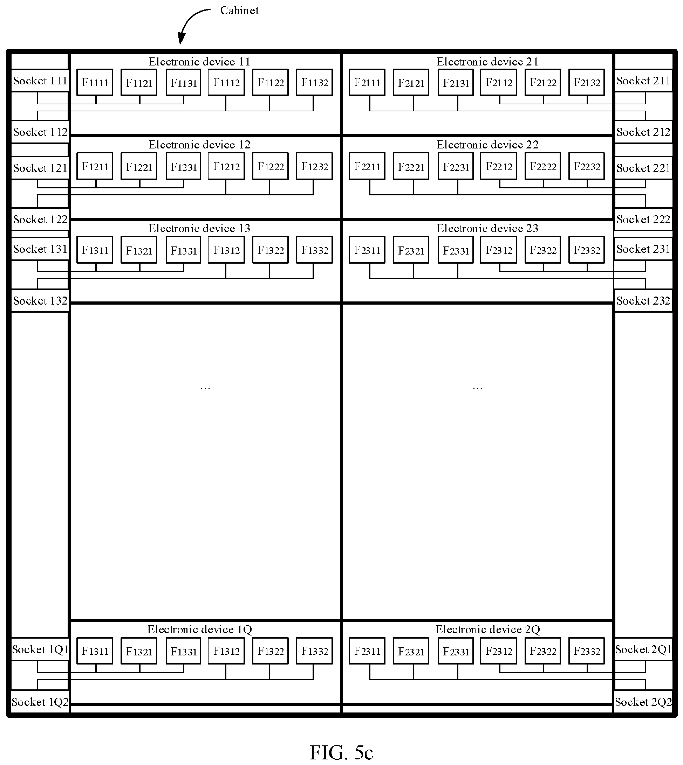

As shown in FIG. 5c, 2*Q electronic devices are disposed in the cabinet, are arranged into Q rows and two columns, and are denoted as an electronic device 11, an electronic device 12, ..., an electronic device 1Q, an electronic device 21, an electronic device 22, ..., and an electronic device 2Q. Three power sources are disposed for each electronic device, two power input ports are disposed for each power source, and correspondingly, six external power ports are disposed. Six external power ports of an electronic device ij are denoted as Fij11, Fij21, Fij31, Fij12, Fij22, and Fij32. Fij11 represents the first external power port of the first power source of the electronic device ij, and Fij21 represents the second external power port of the second power source of the electronic device ij . Fij31, Fij12, Fij22, and Fij32 are similar, and details are not described again. Herein, i=1, 2, and j=1, 2, ..., Q.

Further, each of the Q electronic devices is connected to two sockets, and a total of 4*Q sockets are connected. The 4*Q sockets are horizontally disposed inside the cabinet, and are located on left and right sides of the Q electronic devices. Q sockets disposed on the left side of the Q electronic devices are denoted as a socket 111, a socket 112, ..., a socket 1Q1, and a socket 1Q2. Q sockets disposed on the right side of the Q electronic devices are denoted as a socket 211, a socket 212, ..., a socket 2Q1, and a socket 2Q2. The external power interfaces Fij11, Fij21 and Fij31 of the electronic device ij are connected to a socket 1j1, and the external power interfaces Fij 11, Fij21 and Fij31 are connected to a socket 2ji. FIG. 5c is merely an example, and imposes no specific limitation. In actual application, the 4*Q sockets may be disposed on the left side or the right side of the Q electronic devices, or may be disposed on a rear side thereof. In addition, the foregoing implementation is applied to a scenario in which power sources disposed for Q electronic devices in one column are the same, for example, the electronic device in FIG. 2, and is also applied to a scenario in which power sources of Q electronic devices in one column are of different types, for example, power specifications corresponding to the three power sources of the electronic device 11 are different from power specifications corresponding to the three power sources of the electronic device 12.

Scenario 2: The electronic device may be a cabinet, the cabinet is configured to accommodate a plurality of servers, and the N power sources are used to supply power to the plurality of servers. The N power sources may be arranged into one column, or may be arranged into a plurality of columns. This is not specifically limited in this embodiment of the present invention, and may be specifically determined based on an actual requirement. Generally, the cabinet has a large quantity of power sources. These power sources are arranged into a matrix.

For example, the sockets may be disposed on a left side of the N power sources. In this case, two parallel connection brackets are disposed on an outer surface of the left side of the N power sources, and the two parallel connection brackets are used to mount one or more sockets, so that the sockets are mounted on the left side of the electronic device. For example, the two connection brackets are disposed on the left inner surface, the front inner surface and the rear inner surface, or the upper inner surface and the lower inner surface. In addition, when the two connection brackets are perpendicular to the bottom surface of the cabinet, the sockets are horizontally disposed, that is, the sockets are parallel to the bottom surface of the cabinet. When the two connection brackets are parallel to the bottom surface of the cabinet, the sockets are vertically disposed, that is, the sockets are perpendicular to the bottom surface of the cabinet.

For example, the sockets may be disposed on the right, upper, and rear sides of the N power sources. For details, refer to the content that the sockets are disposed on the left side of the N power sources. Details are not described again.

In actual application, the plurality of sockets may be disposed on any side of the cabinet such as the left side, the right side, the upper side, and the rear side. Alternatively, the plurality of sockets may be disposed on opposite sides of the cabinet such as the left side and the right side. The plurality of sockets may be horizontally or vertically disposed. This is not specifically limited in this embodiment of the present invention, and may be specifically determined based on an actual requirement.

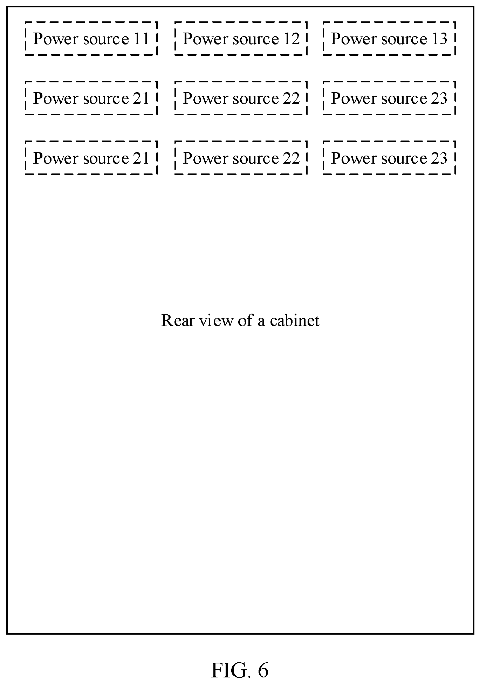

FIG. 6 is a schematic diagram of arrangement of power sources of a cabinet according to an embodiment of the present invention. FIG. 6 shows arrangement of nine power sources in a cabinet. The nine power sources are arranged into a matrix of three rows and three columns, and are denoted as a power source 11, a power source 12, ..., and a power source 33. Herein, power specifications corresponding to the nine power sources are the same.

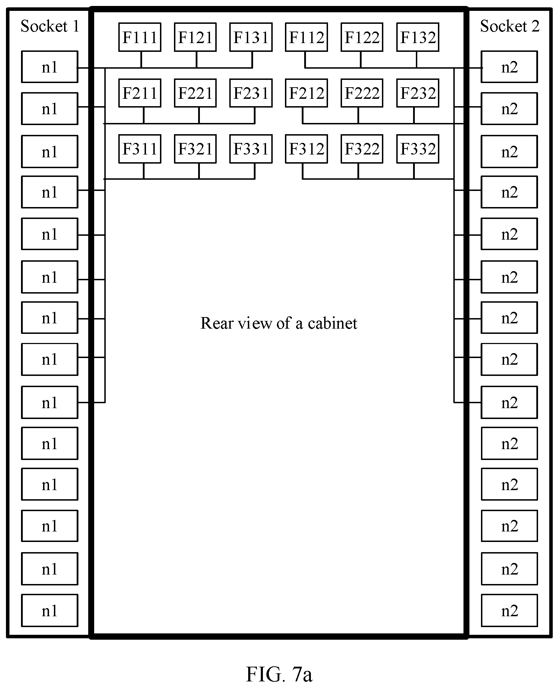

FIG. 7a to FIG. 7d are a schematic diagram 1 and a schematic diagram 4 of connecting, to a socket, an external power port on a housing of the cabinet provided in FIG. 6.

It is assumed that two power input ports are disposed for each power source, power specifications of the two power input ports are the same, and power supply manners thereof are different. Correspondingly, 18 external power ports are disposed for the 9 power sources. Two external power ports of a power source ij are denoted as Fij1 and Fij2. Fij1 represents the first external power port of the power source ij, and Fij2 represents the second external power port of the power source ij. Herein, the 9 power sources are generally the same.

External power ports F111, F121, F131, F211, F221, F231, F311, F321, and F331 may be used as one sub-structure to be connected to a power source in a power supply manner, for example, a power source in the primary power supply manner, and external power ports F112, F122, F132, F212, F222, F232, F312, F322, and F332 are used as another sub-structure to be connected to a power source in another power supply manner, for example, a power source in the backup power supply manner.

As shown in FIG. 7a, the 18 external power ports are connected to two sockets, denoted as a socket 1 and a socket 2. The socket 1 and the socket 2 are vertically disposed outside the cabinet, and respectively are located on left and right sides of the 9 power sources. The socket 1 is disposed on the left side of the9 power sources, and the socket 2 is disposed on the right side of the 9 power sources. F111, F121, F131, F211, F221, F231, F311, F321, and F331 are connected to the socket 1, and F112, F122, F132, F212, F222, F232, F312, F322, and F332 are connected to the socket 2.

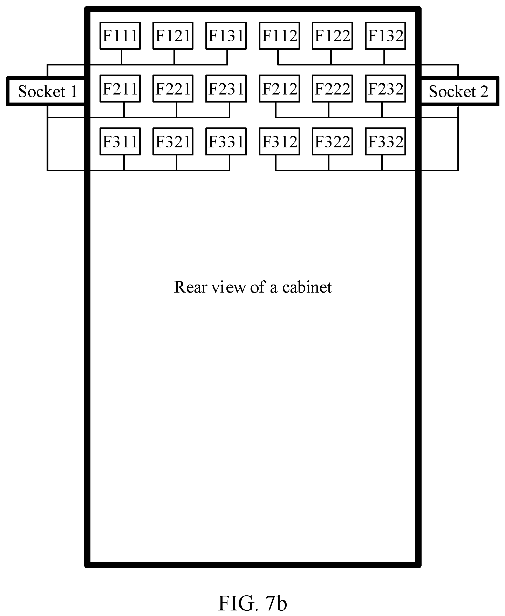

As shown in FIG. 7b, the 18 external power ports are connected to two sockets, denoted as a socket 1 and a socket 2. The socket 1 and the socket 2 are horizontally disposed outside the cabinet, and respectively are located on left and right sides of the 9 power sources. The socket 1 is disposed on the left side of the 9 power sources, and the socket 2 is disposed on the right side of the9 power sources. F111, F121, F131, F211, F221, F231, F311, F321, and F331 are connected to the socket 1, and F112, F122, F132, F212, F222, F232, F312, F322, and F332 are connected to the socket 2.

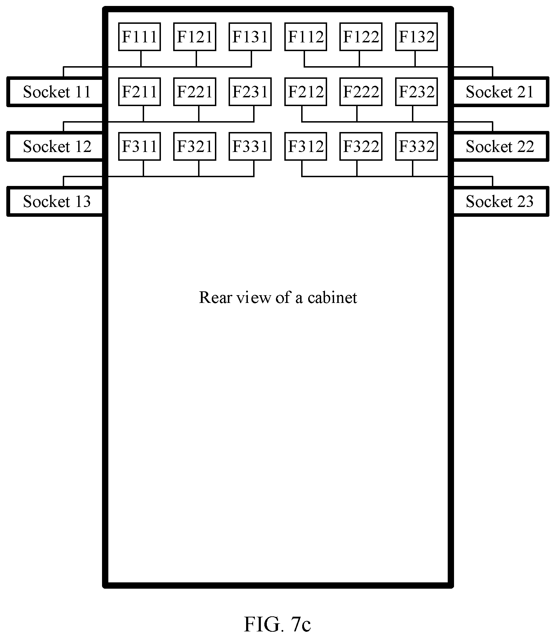

As shown in FIG. 7c, six external power ports in each row are connected to two sockets, and the 18 external power ports are connected to six sockets, denoted as a socket 11, a socket 12, a socket 13, a socket 21, a socket 22, and a socket 23. The six sockets are horizontally disposed outside the cabinet, and respectively are located on left and right sides of the nine power sources. The socket 11, the socket 12, and the socket 13 are disposed on the left side of the nine power sources, and the socket 21, the socket 22, and the socket 23 are disposed on the right side of the nine power sources. F111, F121, and F131 are connected to the socket 11, F211, F221, and F231 are connected to the socket 12, F311, F321, and F331 are connected to the socket 13, F112, F122, and F132 are connected to the socket 21, F132, F212, and F222 are connected to the socket 22, and F232, F312, F322, and F332 are connected to the socket 23. FIG. 7c is merely an example, and imposes no specific limitation. In actual application, the six sockets may be disposed on the left side, the right side, or the upper side of the nine power sources, or may be disposed on a rear side thereof.

In the foregoing connection manners between the external power port and the socket shown in FIG. 7a to FIG. 7c, the foregoing connection manners shown in any one of FIG. 2, FIG. 3a, and FIG. 3b may be used for the 18 power input ports of the nine power sources and the 18 external power ports. Only when the power conversion board is used, one power conversion board is required for three power sources in each row, and a total of three power conversion boards is required.

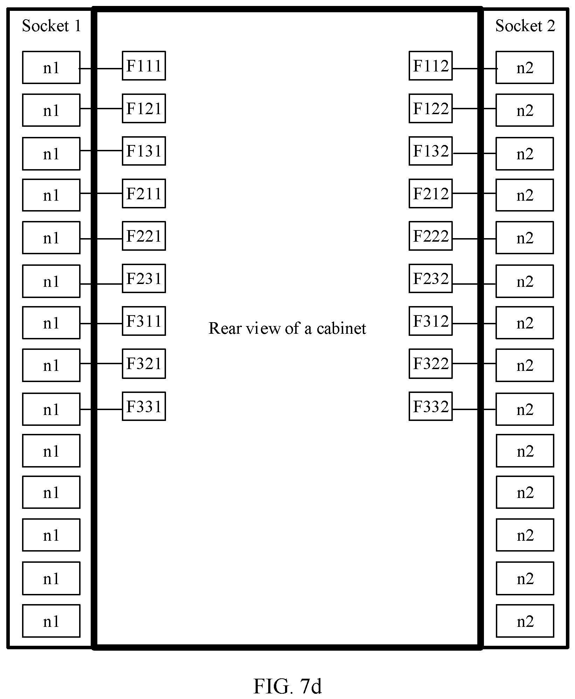

As shown in FIG. 7d, the 18 external power ports are connected to two sockets, denoted as a socket 1 and a socket 2. The socket 1 and the socket 2 are vertically disposed outside the cabinet, and respectively are located on left and right sides of the nine power sources. The socket 1 is disposed on the left side of the nine power sources, and the socket 2 is disposed on the right side of the nine power sources. The 18 power input ports of the nine power sources and the 18 external power ports are connected to each other by power cables. F111, F121, F131, F211, F221, F231, F311, F321, and F331 are arranged into one column to be connected to the socket 1, and F112, F122, F132, F212, F222, F232, F312, F322, and F332 are arranged into one column to be connected to the socket 2. FIG. 7d is merely an example and imposes no specific limitation, and a structure of the 18 external power ports may be designed based on an actual requirement.

In the foregoing connection manner between the external power port and the socket shown in FIG. 7d, the foregoing connection manner shown in FIG. 2 may be used for the 18 power input ports of the 9 power sources and the 18 external power ports.

Based on the foregoing technical solutions, an embodiment of the present invention provides another electronic device.

An electronic device includes: N power sources, where a plurality of power input ports are disposed for each power source, and M power input ports are disposed for the N power sources in total; a connection module, including M external power ports; and a connection board, where M external power ports are disposed on the connection board. The N power sources, the connection module, and the M external power ports are disposed inside the electronic device. Further, the M external power ports and the M power input ports are connected to each other in a one-to-one correspondence inside a housing with cross-cabling, so that an initial structure representing the M power input ports is transformed into a target structure representing the M external power ports on the connection board, and no external space of the electronic device is occupied.

It should be understood that the M external power ports run through the connection board, and a wiring connection member is disposed on a side that is of the external power port and that is away from the power source.

In a feasible implementation, N power sources, a connection module, a connection board, and a plurality of sockets are disposed inside the housing of the electronic device, and the sockets are connected to the external power ports on the connection board through cabling inside the housing by using a hidden structure, so that no external space of the electronic device is occupied.

In actual application, the electronic device may be a cabinet, and a plurality of sockets inside a housing of the cabinet may be disposed on a left, right, upper, lower, or rear side of the N power sources. Alternatively, a plurality of sockets may be disposed on left and right sides or upper and lower sides of the cabinet. The plurality of sockets may be horizontally or vertically disposed. This is not specifically limited in this embodiment of the present invention, and may be specifically determined based on an actual requirement. For details, refer to the foregoing descriptions. Details are not described again.

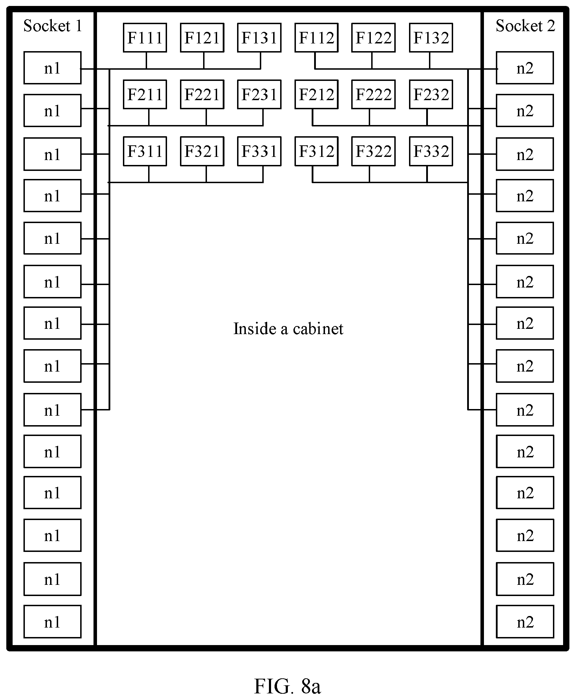

FIG. 8a to FIG. 8d are a schematic diagram 1 to a schematic diagram 4 of connecting an external power port to a socket in the cabinet provided in FIG. 6.

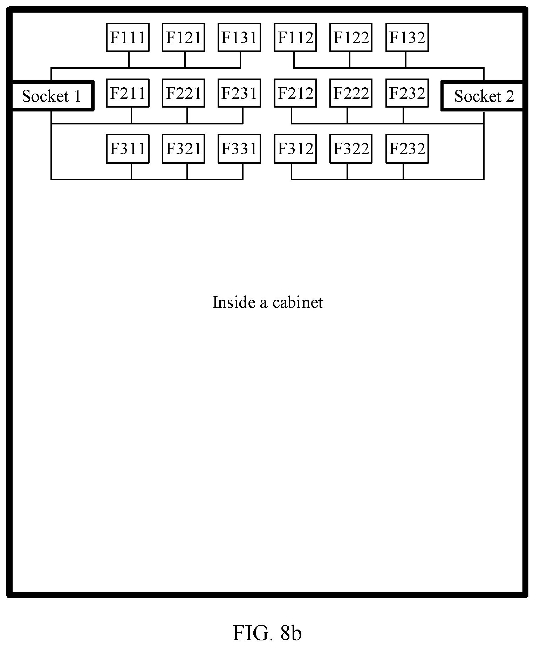

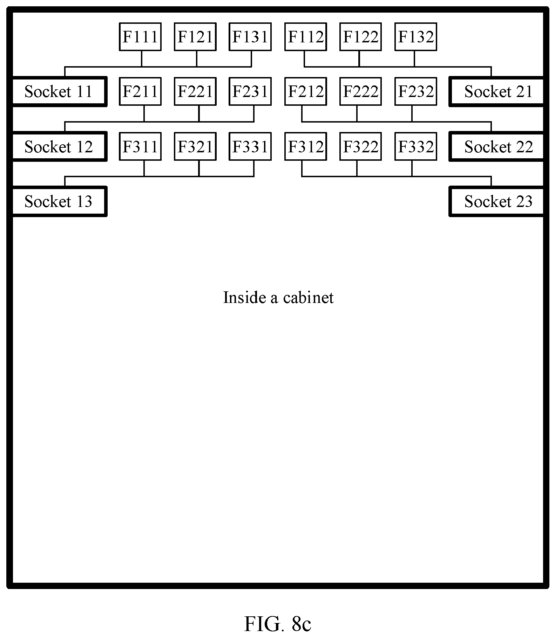

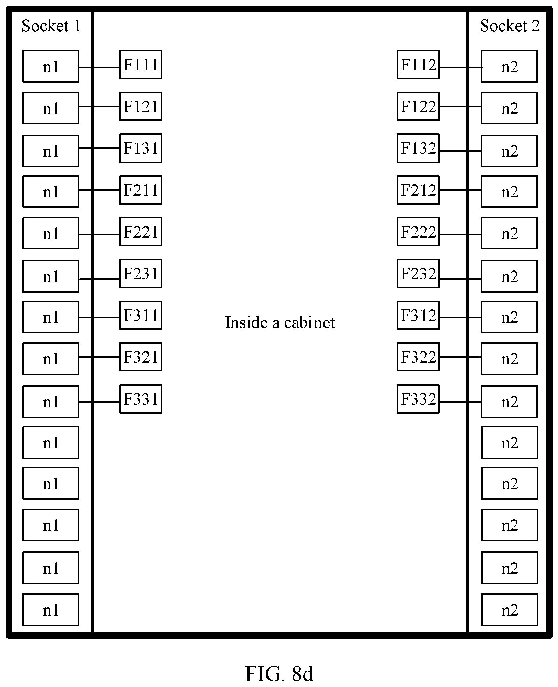

FIG. 8a to FIG. 8d are similar to FIG. 7a to FIG. 7d, and a difference lies only in that the socket is disposed inside the cabinet. Specifically, as shown in FIG. 8a, a socket 1 and a socket 2 are vertically disposed inside the cabinet. As shown in Fig. 8b, a socket 1 and a socket 2 are horizontally disposed inside the cabinet. As shown in Fig. 8c, six sockets are horizontally disposed inside the cabinet. As shown in Fig. 8d, a socket 1 and a socket 2 are vertically disposed inside the cabinet. Other content is similar, and details are not described again.

In a feasible implementation, the external power port and the power input port are connected to each other by power cables. For details, refer to the foregoing descriptions of FIG. 2.

In a feasible implementation, the external power port and the power input port are connected to each other by a power conversion board. For details, refer to the foregoing descriptions of FIG. 3a and FIG. 3b.

In a feasible implementation, the power source can convert only one power specification into a specified power specification (available to the electronic device).

In this implementation, power specifications of the plurality of power input ports disposed for the power source are the same, but power supply manners thereof are different. In this embodiment of the present invention, external power ports that are of different power sources and that have a same power supply manner are collectively represented as one sub-structure on the housing, and areas occupied by sub-structures in different power supply manners do not cross or overlap, to avoid cross-cabling when the external power port is connected to the socket. For details, refer to the foregoing descriptions. Details are not described again.

In a feasible implementation, the power source may convert a plurality of power specifications into specified power specifications (available to the electronic device).

In this implementation, some or all of the plurality of power input ports of the power source have different power specifications, and power input ports having different power specifications need to be connected to power sources having the corresponding power specifications. In this embodiment of the present invention, external power ports that are of different power sources and that have a same power specification are collectively represented as one sub-structure on the connection board, and areas occupied by sub-structures having different power specifications do not cross or overlap, to avoid cross-cabling when the external power port is connected to the socket. For details, refer to the foregoing descriptions. Details are not described again.

In addition, some of the plurality of power input ports of the power source have a same power specification but different power supply manner. For example, one power input port is connected to mains power, and another power input port is connected to a backup power source. Herein, external power ports that are of different power sources and that have a same power supply manner and a same power specification are collectively represented as one sub-structure on the connection board, and areas occupied by sub-structures having different power supply manners and a same power specification do not cross or overlap, to avoid cross-cabling when the external power port is connected to the socket. For details, refer to the foregoing descriptions. Details are not described again.

For the foregoing descriptions, a person of ordinary skill in the art may make various other corresponding modifications and variations based on the technical solutions and technical idea of the present invention, and all these modifications and variations shall fall within the protection scope of the claims of the present invention.

## Claims

1. An electronic device, comprising a plurality of power sources, a connection module, and a housing, wherein
each power source is located inside the housing, at least two power input ports are disposed for each power source, and the power input ports of the plurality of power sources form a first structure;
the device **characterized in that** the the connection module comprises at least two first power ports, the first power ports are disposed on the housing, and a quantity of first power ports is equal to a quantity of power input ports; and
the first power ports on the housing form a second structure, the first structure is different from the second structure, and the power input ports are connected to the first power ports in a one-to-one correspondence.

2. The electronic device according to claim 1, wherein cables connecting the first power ports corresponding to the second structure and a plurality of sockets do not cross.

3. The electronic device according to claim 2, wherein the second structure comprises a plurality of sub-structures, and the first power ports corresponding to the plurality of sub-structures are connected to the plurality of sockets in a one-to-one correspondence, and regions occupied by different sub-structures on the housing do not intersect or overlap.

4. The electronic device according to any one of claims 3, wherein the plurality of power sources comprise a plurality of target power sources, at least two power input ports of each target power source comprise at least one first-type power input port and at least one second-type power input port, a power supply manner of the first-type power input port is a primary power supply manner, and a power supply manner of the second-type power input port is a backup power supply manner; and
the plurality of sub-structures comprise a primary power supply structure and a backup power supply structure, the primary power supply structure is connected to the first-type power input port, and the backup power supply structure is connected to the second-type power input port.

5. The electronic device according to any one of claims 1 to 4, wherein the power input port is connected to the first power port by a power cable.

6. The electronic device according to any one of claims 1 to 4, wherein the power input port is connected to the first power port by a power conversion board, a side that is of the power conversion board and that is close to the plurality of power sources is connected to the power input port, and a side that is of the power conversion board and that is close to the plurality of connection modules is connected to the first power port.

7. The electronic device according to claim 6, wherein the at least two power input ports of the power source are connected to a board connection module, and the board connection module is connected to the power conversion board, to connect the at least two power input ports of the power source to the power conversion board by the board connection module.

8. A cabinet, wherein the cabinet comprising at least one electronic device according to claim 1.

9. The cabinet according to claim 8, wherein cables connecting the first power ports corresponding to the second structure and a plurality of sockets do not cross.

10. The cabinet according to claim 9, wherein the second structure comprises a plurality of sub-structures, the first power ports corresponding to the plurality of sub-structures are connected to the plurality of sockets in a one-to-one correspondence, and regions occupied by different sub-structures on the housing do not intersect or overlap.

11. The cabinet according to claim 8, wherein the plurality of power sources comprise a plurality of target power sources, at least two power input ports of each target power source comprise at least one first-type power input port and at least one second-type power input port, a power supply manner of the first-type power input port is a primary power supply manner, and a power supply manner of the second-type power input port is a backup power supply manner; and
the plurality of sub-structures comprise a primary power supply structure and a backup power supply structure, the primary power supply structure is connected to the first-type power input port, and the backup power supply structure is connected to the second-type power input port.

12. The cabinet according to claim 8, wherein the power input port is connected to the first power port by a power cable.

13. The cabinet according to claim 8, wherein the power input port is connected to the first power port by a power conversion board, a side that is of the power conversion board and that is close to the plurality of power sources is connected to the power input port, and a side that is of the power conversion board and that is close to the connection modules is connected to the first power port.

14. The cabinet according to claim 13, wherein the at least two power input ports of the power source are connected to a board connection module, and the board connection module is connected to the power conversion board, to connect the at least two power input ports of the power source to the power conversion board by the board connection module.

## Patentansprüche

1. Elektronische Vorrichtung, umfassend eine Vielzahl von Stromquellen, ein Verbindungsmodul und ein Gehäuse, wobei
sich jede Stromquelle innerhalb des Gehäuses befindet, mindestens zwei Stromeingangsanschlüsse für jede Stromquelle angeordnet sind und die Stromeingangsanschlüsse der Vielzahl von Stromquellen eine erste Struktur ausbilden;
wobei die Vorrichtung **dadurch gekennzeichnet ist, dass** das Verbindungsmodul mindestens zwei erste Stromanschlüsse umfasst, die ersten Stromanschlüsse auf dem Gehäuse angeordnet sind und eine Anzahl erster Stromanschlüsse gleich einer Anzahl von Stromeingangsanschlüssen ist; und
die ersten Stromanschlüsse auf dem Gehäuse eine zweite Struktur ausbilden, die erste Struktur von der zweiten Struktur verschieden ist und die Stromeingangsanschlüsse in einer Eins-zu-Eins-Entsprechung mit den ersten Stromanschlüssen verbunden sind.

2. Elektronische Vorrichtung nach Anspruch 1, wobei sich Kabel, die die ersten Stromanschlüsse, die der zweiten Struktur entsprechen, und eine Vielzahl von Steckdosen verbinden, nicht kreuzen.

3. Elektronische Vorrichtung nach Anspruch 2, wobei die zweite Struktur eine Vielzahl von Unterstrukturen umfasst und die ersten Stromanschlüsse, die der Vielzahl von Unterstrukturen entsprechen, in einer Eins-zu-Eins-Entsprechung mit der Vielzahl von Steckdosen verbunden sind und sich Bereiche, die durch verschiedene Unterstrukturen auf dem Gehäuse belegt sind, nicht schneiden oder überlappen.

4. Elektronische Vorrichtung nach einem der Ansprüche 3, wobei die Vielzahl von Stromquellen eine Vielzahl von Zielstromquellen umfasst, mindestens zwei Stromeingangsanschlüsse jeder Zielstromquelle mindestens einen Stromeingangsanschluss einer ersten Art und mindestens einen Stromeingangsanschluss einer zweiten Art umfassen, eine Stromversorgungsweise des Stromeingangsanschlusses der ersten Art eine primäre Stromversorgungsweise ist und eine Stromversorgungsweise des Stromeingangsanschlusses der zweiten Art eine Reservestromversorgungsweise ist; und
die Vielzahl von Unterstrukturen eine primäre Stromversorgungsstruktur und eine Reservestromversorgungsstruktur umfasst, die primäre Stromversorgungsstruktur mit dem Stromeingangsanschluss der ersten Art verbunden ist und die Reservestromversorgungsstruktur mit dem Stromeingangsanschluss der zweiten Art verbunden ist.

5. Elektronische Vorrichtung nach einem der Ansprüche 1 bis 4, wobei der Stromeingangsanschluss durch ein Stromkabel mit dem ersten Stromanschluss verbunden ist.

6. Elektronische Vorrichtung nach einem der Ansprüche 1 bis 4, wobei der Stromeingangsanschluss durch eine Stromumwandlungsplatine mit dem ersten Stromanschluss verbunden ist, eine Seite, die von der Stromumwandlungsplatine ist und die in der Nähe der Vielzahl von Stromquellen ist, mit dem Stromeingangsanschluss verbunden ist und eine Seite, die von der Stromumwandlungsplatine ist und die in der Nähe der Vielzahl von Verbindungsmodulen ist, mit dem ersten Stromanschluss verbunden ist.

7. Elektronische Vorrichtung nach Anspruch 6, wobei die mindestens zwei Stromeingangsanschlüsse der Stromquelle mit einem Platinenverbindungsmodul verbunden sind und das Platinenverbindungsmodul mit der Stromumwandlungsplatine verbunden ist, um die mindestens zwei Stromeingangsanschlüsse der Stromquelle durch das Platinenverbindungsmodul mit der Stromumwandlungsplatine zu verbinden.

8. Schrank, wobei der Schrank mindestens eine elektronische Vorrichtung nach Anspruch 1 umfasst.

9. Schrank nach Anspruch 8, wobei sich Kabel, die die ersten Stromanschlüsse, die der zweiten Struktur entsprechen, und eine Vielzahl von Steckdosen verbinden, nicht kreuzen.

10. Schrank nach Anspruch 9, wobei die zweite Struktur eine Vielzahl von Unterstrukturen umfasst, die ersten Stromanschlüsse, die der Vielzahl von Unterstrukturen entsprechen, in einer Eins-zu-Eins-Entsprechung mit der Vielzahl von Steckdosen verbunden sind und sich Bereiche, die durch verschiedene Unterstrukturen auf dem Gehäuse belegt sind, nicht schneiden oder überlappen.

11. Schrank nach Anspruch 8, wobei die Vielzahl von Stromquellen eine Vielzahl von Zielstromquellen umfasst, mindestens zwei Stromeingangsanschlüsse jeder Zielstromquelle mindestens einen Stromeingangsanschluss der ersten Art und mindestens einen Stromeingangsanschluss der zweiten Art umfassen, eine Stromversorgungsweise des Stromeingangsanschlusses der ersten Art eine primäre Stromversorgungsweise ist und eine Stromversorgungsweise des Stromeingangsanschlusses der zweiten Art eine Reservestromversorgungsweise ist; und
die Vielzahl von Unterstrukturen eine primäre Stromversorgungsstruktur und eine Reservestromversorgungsstruktur umfasst, die primäre Stromversorgungsstruktur mit dem Stromeingangsanschluss der ersten Art verbunden ist und die Reservestromversorgungsstruktur mit dem Stromeingangsanschluss der zweiten Art verbunden ist.

12. Schrank nach Anspruch 8, wobei der Stromeingangsanschluss durch ein Stromkabel mit dem ersten Stromanschluss verbunden ist.

13. Schrank nach Anspruch 8, wobei der Stromeingangsanschluss durch eine Stromumwandlungsplatine mit dem ersten Stromanschluss verbunden ist, eine Seite, die von der Stromumwandlungsplatine ist und die in der Nähe der Vielzahl von Stromquellen ist, mit dem Stromeingangsanschluss verbunden ist und eine Seite, die von der Stromumwandlungsplatine ist und die in der Nähe der Verbindungsmodule ist, mit dem ersten Stromanschluss verbunden ist.

14. Schrank nach Anspruch 13, wobei die mindestens zwei Stromeingangsanschlüsse der Stromquelle mit einem Platinenverbindungsmodul verbunden sind und das Platinenverbindungsmodul mit der Stromumwandlungsplatine verbunden ist, um die mindestens zwei Stromeingangsanschlüsse der Stromquelle durch das Platinenverbindungsmodul mit der Stromumwandlungsplatine zu verbinden.

## Revendications

1. Dispositif électronique comprenant une pluralité de sources d'alimentation, un module de connexion et un boîtier, dans lequel
chaque source d'alimentation est située à l'intérieur du boîtier, au moins deux ports d'entrée d'alimentation sont disposés pour chaque source d'alimentation, et les ports d'entrée d'alimentation de la pluralité des sources d'alimentation forment une première structure ;
le dispositif étant **caractérisé en ce que** le module de connexion comprend au moins deux premiers ports d'alimentation, les premiers ports d'alimentation sont disposés sur le boîtier, et leur nombre est égal au nombre de ports d'entrée d'alimentation ; et
les premiers ports d'alimentation du boîtier forment une seconde structure, la première structure est différente de la seconde structure, et les ports d'entrée d'alimentation sont reliés aux premiers ports d'alimentation selon une correspondance biunivoque.

2. Dispositif électronique selon la revendication 1, dans lequel les câbles reliant les premiers ports d'alimentation correspondant à la seconde structure et une pluralité de prises ne se croisent pas.

3. Dispositif électronique selon la revendication 2, dans lequel la seconde structure comprend une pluralité de sous-structures, et les premiers ports d'alimentation correspondant à la pluralité de sous-structures sont reliés aux pluralités de prises dans une correspondance biunivoque, et les régions occupées par différentes sous-structures sur le boîtier ne s'intersectent ni ne se chevauchent.

4. Dispositif électronique selon l'une quelconque des revendications 3, dans lequel la pluralité de sources d'alimentation comprend une pluralité de sources d'alimentation cibles, au moins deux ports d'entrée d'alimentation de chaque source d'alimentation cible comprend au moins un port d'entrée d'alimentation de premier type et au moins un port d'entrée d'alimentation de second type, un mode d'alimentation du port d'entrée d'alimentation de premier type est un mode d'alimentation principal et un mode d'alimentation du port d'entrée d'alimentation de second type est un mode d'alimentation de secours ; et
la pluralité de sous-structures comprend une structure d'alimentation principale et une structure d'alimentation de secours, la structure d'alimentation principale est reliée au port d'entrée d'alimentation de premier type, et la structure d'alimentation de secours est reliée au port d'entrée d'alimentation de second type.

5. Dispositif électronique selon l'une quelconque des revendications 1 à 4, dans lequel le port d'entrée d'alimentation est relié au premier port d'alimentation par un câble d'alimentation.

6. Dispositif électronique selon l'une quelconque des revendications 1 à 4, dans lequel le port d'entrée d'alimentation est relié au premier port d'alimentation par une carte de conversion de puissance, un côté de la carte de conversion de puissance qui est proche de la pluralité de sources d'alimentation est relié au port d'entrée d'alimentation, et un côté de la carte de conversion de puissance qui est proche de la pluralité de modules de connexion est relié au premier port d'alimentation.

7. Dispositif électronique selon la revendication 6, dans lequel les au moins deux ports d'entrée d'alimentation de la source d'alimentation sont reliés à un module de connexion de carte, et le module de connexion de carte est relié à la carte de conversion de puissance, pour connecter les au moins deux ports d'entrée d'alimentation de la source d'alimentation à la carte de conversion de puissance par le module de connexion de carte.

8. Armoire, dans lequel l'armoire comprenant au moins un dispositif électronique selon la revendication 1.

9. Armoire selon la revendication 8, dans lequel les câbles reliant les premiers ports d'alimentation correspondant à la seconde structure et une pluralité de prises ne se croisent pas.

10. Armoire selon la revendication 9, dans lequel la seconde structure comprend une pluralité de sous-structures, et les premiers ports d'alimentation correspondant à la pluralité de sous-structures sont reliés à la pluralité de prises dans une correspondance biunivoque, et les régions occupées par différentes sous-structures sur le boîtier ne s'intersectent ni ne se chevauchent.

11. Armoire selon la revendication 8, dans lequel la pluralité de sources d'alimentation comprend une pluralité de sources d'alimentation cibles, au moins deux ports d'entrée d'alimentation de chaque source d'alimentation cible comprend au moins un port d'entrée d'alimentation de premier type et au moins un port d'entrée d'alimentation de second type, un mode d'alimentation du port d'entrée d'alimentation de premier type est un mode d'alimentation principal et un mode d'alimentation du port d'entrée d'alimentation de second type est un mode d'alimentation de secours ; et
la pluralité de sous-structures comprend une structure d'alimentation principale et une structure d'alimentation de secours, la structure d'alimentation principale est reliée au port d'entrée d'alimentation de premier type, et la structure d'alimentation de secours est reliée au port d'entrée d'alimentation de second type.

12. Boîtier selon la revendication 8, dans lequel le port d'entrée d'alimentation est relié au premier port d'alimentation par un câble d'alimentation.

13. Armoire selon la revendication 8, dans lequel le port d'entrée d'alimentation est relié au premier port d'alimentation par une carte de conversion de puissance, un côté de la carte de conversion de puissance qui est proche de la pluralité de sources d'alimentation est relié au port d'entrée d'alimentation, et un côté de la carte de conversion de puissance qui est proche des modules de connexion est relié au premier port d'alimentation.

14. Armoire selon la revendication 13, dans lequel les au moins deux ports d'entrée d'alimentation de la source d'alimentation sont reliés à un module de connexion de carte, et le module de connexion de carte est relié à la carte de conversion de puissance, pour relier les au moins deux ports d'entrée d'alimentation de la source d'alimentation à la carte de conversion de puissance par le module de connexion de carte.
